(19) Europäisches Patentamt
European Patent Office
Office européen des brevets

(11) **EP 4 525 557 B1**

(12) **EUROPEAN PATENT SPECIFICATION**

(45) Date of publication and mention
of the grant of the patent:
**13.05.2026 Bulletin 2026/20**

(21) Application number: **24197198.5**

(22) Date of filing: **29.08.2024**

(51) International Patent Classification (IPC):
*H05B 45/50* (2022.01)      *H05B 47/20* (2020.01)
*H05B 45/46* (2020.01)      *G01R 19/00* (2006.01)
*H02M 1/00* (2006.01)

(52) Cooperative Patent Classification (CPC):
**H05B 45/50; G01R 19/0092; H02M 1/0009;
H05B 45/46; H05B 47/20**

(54) **POWER SUPPLY CIRCUIT, RELATED SYSTEM AND METHOD**

STROMVERSORGUNGSSCHALTUNG, ZUGEHÖRIGES SYSTEM UND VERFAHREN

CIRCUIT D'ALIMENTATION ÉLECTRIQUE, SYSTÈME ET PROCÉDÉ ASSOCIÉS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **12.09.2023 IT 202300018681**

(43) Date of publication of application:
**19.03.2025 Bulletin 2025/12**

(73) Proprietor: **STMicroelectronics International N.V.
1228 Plan-les-Ouates, Geneva (CH)**

(72) Inventors:
• **POLISI, Vincenzo
  I-95038 Santa Maria di Licodia (Catania) (IT)**
• **TAGLIAVIA, Donato
  95024 Acireale (CT) (IT)**
• **TRECARICHI, Calogero Andrea
  I-93012 Gela (Caltanissetta) (IT)**
• **DONDINI, Mirko
  95126 Catania (IT)**

(74) Representative: **Buzzi, Notaro & Antonielli d'Oulx
S.p.A.
Corso Vittorio Emanuele II, 6
10123 Torino (IT)**

(56) References cited:
**US-B2- 10 893 591      US-B2- 9 451 664**

**Description**

Technical field

The embodiments of the present description refer to power supply circuits, such as power supply circuits configured to supply lighting modules.

Description of the relevant art

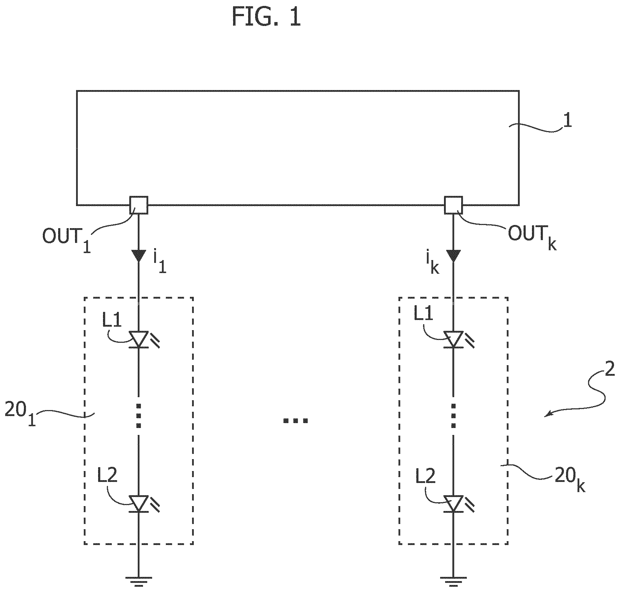

Figure 1 shows a typical lighting system. The lighting system includes a power supply circuit 1 and one or more lighting modules 20, such as lighting modules $20_1$ to $20_k$. For example, the lighting modules 20 may form a LED or OLED panel 2.

In the example considered, each lighting module 20 includes one or more lighting sources. For example, in the example considered, each lighting module 20 including at least one LED (Light Emitting Diode) or OLED (organic light-emitting diode) L. For example, often each lighting module 20 includes a LED string, i.e., a plurality of LEDs connected in series, as schematically shown via two LEDs L1 and L2 connected in series.

The person skilled in the art will appreciate that a LED (or a LED chain) is usually not supplied with a constant voltage but rather via a current. Accordingly, in order to individually control the light intensity of each lighting module 20, the power supply circuit 1 usually comprises for each lighting module 20 a respective output terminal or channel OUT, such as output terminals $OUT_1$ to $OUT_k$, and the power supply circuit 1 is configured to provide to each output terminal OUT a respective current, such as currents $i_1$ to $i_k$.

Such power supply circuits 1 are well-known in the art. For example, the applicant of the present patent application sells LED driver integrated circuits, such as the L99LDLH32 having 32 channels. For example, the operation of the L99LDLH32 is described in the datasheet DS12879, "*L99LDLH32 - 32-channel LED driver with automotive CAN FD Light interface*," e.g., revision 5 of 2021.

In many applications, the power supply circuit 1 should be able to monitor each of the currents $i_1$ to $i_k$. For example, such a monitoring may be useful in order to verify whether each current provided by the power supply circuit 1 corresponds to an expected value or more generally is within an expected tolerance range, which, e.g., permits to determine whether the intensity of the light emitted by a lighting module 20 correspond to an expected value and/or whether a lighting module represents a malfunction, e.g., due to a short-circuit or open-load condition.

Accordingly, the present invention relates to a power supply circuit according to the preamble of Claim 1, which is known, e.g. from document US 9,451,664 B2. Document US 10,893,591 B2 may also be of interest for the present application.

Object and summary

Considering the foregoing, an object of various embodiments of the present disclosure is to provide solutions for verifying the current supply conditions of a power supply circuit.

According to one or more embodiments, the above object is achieved by a power supply circuit having the distinctive elements set forth specifically in the ensuing claims. The embodiments moreover concern a related system and method.

The claims form an integral part of the technical teaching of the description provided herein.

As mentioned before, various embodiments of the present disclosure relate to a power supply circuit. In various embodiments, the power supply circuit comprises a plurality of output terminals, such as pads or pins of a respective integrated circuit comprising the power supply circuit, and for each output terminal a respective current supply circuit. Specifically, each current supply circuit is configured to provide an output current to the respective output terminal as a function of a respective first digital control signal.

For example, in various embodiments, each current supply circuit comprises a current digital-to-analog converter configured to receive a first reference current and the respective first digital control signal, wherein the first digital control signal is indicative of a first multiplier, and the current digital-to-analog converter is configured to generate a first current by multiplying the first reference current with the first multiplier. Moreover, each current supply circuit comprises a scaling circuit configured to generate the output current by generating an amplified version of the first current according to a first scaling factor.

For example, in various embodiments each current supply circuit comprises a first resistance connected between a regulated voltage and an output of the current digital-to-analog converter, a second resistance connected with the current path of the first FET between the regulated voltage and the respective output terminal, and an operational amplifier configured to drive the gate-source voltage of the first FET such that the voltage-drop at the second resistance corresponds to the voltage-drop at the first resistance. Accordingly, in this case, the ratio between the resistance value of the second resistance and the resistance value of the first resistance defines the first scaling factor.

In various embodiments, each current supply circuit comprises also a current sensor configured to provide a measurement current being proportional to the respective output current. For example, in various embodiments, the current sensor comprises a third resistance connected in series with the current path of a second FET to the regulated voltage, wherein the gate terminal of the second FET is connected to the gate terminal of the first FET. Accordingly, the resistance value of the third resistance and the scaling of the second FET with respect to the first FET define a second scaling factor. Preferably, the ratio between the first scaling factor and the second scaling factor is one.

Accordingly, in various embodiments, the current supply circuit comprises a first FET connected between the regulated voltage and the respective output terminal, and the current sensor comprises a second FET configured to provide the measurement current, wherein the current supply circuit is configured such that the gate-source voltage of the second FET corresponds to the gate-source voltage of the first FET.

In various embodiments, the power supply circuit comprises a first multiplexer circuit, a second multiplexer circuit, a comparison circuit and a control circuit. Specifically, the first multiplexer circuit is configured to provide a selected measurement current by selecting one of the measurement currents as a function of a selection signal indicating a selected current supply circuit. Conversely, the second multiplexer circuit is configured to provide a selected digital control signal by selecting one of the first digital control signals as a function of the selection signal indicating a selected current supply circuit.

In various embodiments, the comparison circuit is configured to generate a threshold current as a function of one or more digital threshold control signals. For example, in various embodiments, the one or more digital threshold control signals comprise a second digital control signal, and the comparison circuit comprises a further current digital-to-analog converter configured to receive a second reference current and the second digital control signal, wherein the second digital control signal is indicative of a second multiplier, and the further current digital-to-analog converter is configured to generate the threshold current by multiplying the second reference current with the second multiplier.

Moreover, in various embodiments the comparison circuit is configured to compare the selected measurement current with the threshold current. Specifically, in response to determining that the selected measurement current is greater than the threshold current, the comparison circuit de-asserts a comparison signal and, in response to determining that the selected measurement current is smaller than the threshold current, the comparison circuit assert the comparison signal.

For example, for this purpose, the comparison circuit may comprise a summation node configured to provide a current corresponding to the difference between the selected measurement current and the threshold current, and a current comparator configured to de-assert the comparison signal when current is greater than zero, and assert the comparison signal when the current is smaller than zero. Alternatively, the comparison circuit may comprise a first measurement resistance configured to be transversed by the threshold current and a second measurement resistance configured to be transversed by the selected measurement current. In this case, the comparison circuit may comprise a voltage comparator configured to assert the comparison signal when the voltage-drop at the first measurement resistance is greater than the voltage-drop at the second measurement resistance, and de-assert the comparison signal when the voltage-drop at the first measurement resistance is smaller than the voltage-drop at the second measurement resistance.

In various embodiments, the control circuit is configured to repeat various operations periodically. Specifically, the control circuit generates the selection signal in order to select a measurement current and a first digital control signal associated with a given current supply circuit. For example, the control circuit may sequentially select all or a subset of the current supply circuits. Next, the control circuit generates the one or more digital threshold control signals as a function of the selected digital control signal in order to set the threshold current during a first phase to a first value, wherein the first value is smaller than an expected value for the selected measurement current as indicated by the selected digital control signal. Moreover, the control circuit sets the threshold current during a second phase to a second value, wherein the second value is greater than the expected value for the selected measurement current as indicated by the selected digital control signal.

Accordingly, in various embodiments, the first value and the second value may be used to define a tolerance range for the expected value for the selected measurement current. For example, in various embodiments, the control circuit is configured to, during the first phase, set the second digital control signal to a first value being smaller than the selected digital control signal by a given first percentage and, during the second phase, set the second digital control signal to a second value being greater than the selected digital control signal by a given second percentage. Alternatively, the one or more digital threshold control signals may also comprise a reference current selection signal, and the control circuit may, during the first phase, set the second digital control signal to the value of the selected digital control signal and select via the reference current selection signal as the second reference current a current having a value being smaller than the first reference current by a given first percentage and, during the second phase, set the second digital control signal to the value of the selected digital control signal and select via the reference current selection signal as the second reference current a current having a value being greater than the first reference current by a given second tolerance percentage.

In various embodiments, the control circuit verifies then whether the comparison signal is de-asserted during the first phase and asserted during the second phase. Specifically, the control circuit asserts a status signal when the comparison signal is de-asserted during the first phase and asserted during the second phase, and de-asserts the status signal when the comparison signal is asserted during the first phase or de-asserted during the second phase.

Brief description of the annexed drawings

Embodiments of the present disclosure will now be described with reference to the annexed drawings, which are provided purely by way of non-limiting example and in which:

- Figure 1 shows an example of a lighting system;
- Figure 2 shows an embodiment of a power supply circuit;
- Figure 3 shows an embodiment of a current supply circuit of the power supply circuit of Figure 2;
- Figure 4 shows an embodiment of a current source of the current supply circuit of Figure 3;
- Figure 5 shows an embodiment of a current sensor of the current supply circuit of Figure 3;
- Figure 6 shows an embodiment of a current monitoring circuit for the power supply circuit of Figure 2;
- Figures 7A, 7B, 7C and 7D show embodiments of the operation of the current monitoring circuit of Figure 6;
- Figures 8, 9 and 10 show embodiments of comparison circuits of the current monitoring circuit of Figure 6; and
- Figure 11 shows a further embodiment of the operation of the current monitoring circuit of Figure 6.

Detailed description of embodiments

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The references used herein are for convenience only and do not interpret the scope or meaning of the embodiments.

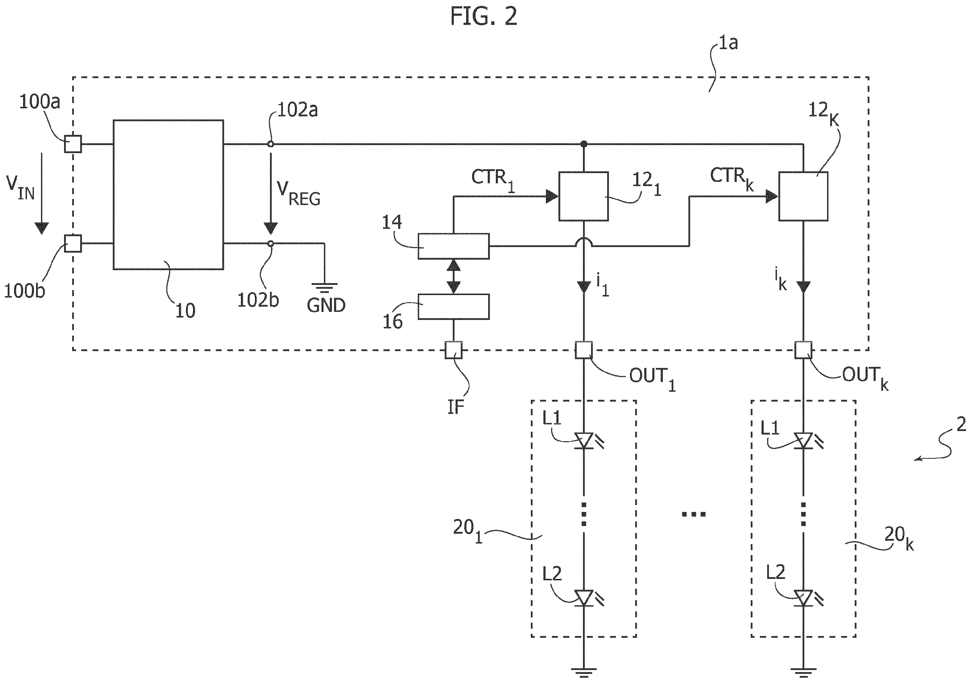

In the following Figures 2 to 11 parts, elements or components which have already been described with reference to Figure 1 are denoted by the same references previously used in such Figure; the description of such previously described elements will not be repeated in the following in order not to overburden the present detailed description.

Figure 2 shows an embodiment of a power supply circuit 1a according to the present disclosure. In various embodiments, the power supply circuit 1a may be implemented within an integrated circuit (IC).

Specifically, in the embodiment considered, the power supply circuit 1a comprises a plurality of output terminals OUT (e.g., pads of a die of the IC of the power supply circuit 1a or pins of a packaged IC of the power supply circuit 1a), such as k output terminals $OUT_1$ to $OUT_k$. In various embodiments, the power supply circuit 1a may be used in a lighting system, wherein one or more lighting modules 20, such as k lighting modules $20_1$ to $20_k$, are connected to the output terminals OUT. In general, the number of lighting modules 20 connected to the power supply circuit 1a may correspond to the number k of output terminals OUT or may be smaller than the number k of output terminals OUT. For example, the number of output terminals, i.e., the channels, may be greater than 4, e.g., between 8 and 256. In various embodiments, each lighting module 20 includes one or more lighting sources, such as LEDs or OLEDs, or other solid state light sources, such as laser diodes. In general, the power supply circuit 1a may also be used to supply other types of loads.

As described in the foregoing, in various embodiments, the power supply circuit 1a is configured to provide to each output terminal OUT a respective current, such as currents $i_1$ to $i_k$. Specifically, in the embodiment considered, the power supply circuit 1a comprises for each output terminal OUT a respective current supply circuit 12, such as current supply circuits $12_1$ to $12_k$, wherein each current supply circuit 12 is configured to provide a respective current.

In the embodiment considered, the current supply circuits 12 are supplied via a common DC voltage $V_{REG}$ applied between two nodes 102a and 102b, wherein the node 102b often represents a ground GND. Accordingly, in the example considered, each lighting module 20 and the respective current supply circuit 12 may thus be connected between the node 102a and the node 102b. In various embodiments, each current supply circuit 12 may be supplied by a respective voltage $V_{REG}$ or sub-sets of the current supply circuits 12 may be supplied by a respective voltage $V_{REG}$. For example, the voltage $V_{REG}$ may be in a range between 5 V and 24 V, e.g., between 9 V and 14 V. However, the voltage $V_{REG}$ may also be greater than 24 V, e.g., in a range between 50 V and 100 V.

In various embodiments, the voltage(s) $V_{REG}$ may be received via input terminals of the power supply circuit 1a, such as two input terminals 100a and 100b (e.g., pads or pins of a respective IC). Alternatively, as shown in Figure 2, the power supply circuit 1a may comprise a voltage generator circuit 10 configured to generate the voltage(s) $V_{REG}$. In this case, the power supply circuit 1a may be configured to receive via the input terminals 100a and 100b an input voltage $V_{IN}$ and the voltage generator circuit 10 may be configured to generate the voltage(s) $V_{REG}$, e.g., generate a regulated voltage $V_{REG}$ at the nodes 102a and 102b, based on the voltage $V_{IN}$. In general, the input voltage $V_{IN}$ may be an AC or DC voltage. For example, in various embodiments, the terminals 100a and 100b may be connected to the mains, an external electronic converter generating a DC voltage or a battery. Accordingly, in various embodiments, the voltage generator circuit 10 may comprise a linear regulator, or an AC/DC or DC/DC electronic converter (switched mode power supply). For example, in various embodiments, the voltage generator circuit 10 is implemented with a DC/DC electronic converter, such as a buck or multi-phase buck converter, a boost converter, a SEPIC converter, or another type of electronic converter. In this case, the reactive components (inductances, such as inductors and/or transformers, and/or capacitors) of such an electronic converter may be external with respect to the IC of the power supply circuit 1a.

In the embodiment considered, each current supply circuit 12 is configured to generate the respective current as a function of one or more respective control signals CTR, such as control signal(s) $CTR_1$ for the current supply circuit $12_1$ and control signal(s) $CTR_k$ for the current supply circuit $12_k$. In various embodiments, the power supply circuit 1a may comprise terminals for receiving the control signals CTR, e.g., from an external microprocessor. Conversely, in other embodiments, as shown in Figure 2, the power supply circuit 1a comprises a control circuit 14 configured to generate the control signals CTR.

For example, in various embodiments, the power supply circuit 1a comprises a communication interface 16, such as a serial communication interface, e.g., a Universal asynchronous receiver/transmitter (UART), Serial Peripheral Interface Bus (SPI), Inter-Integrated Circuit (I2C), Controller Area Network (CAN) bus, and/or Ethernet interface, which is connected to one or more terminals IF of the power supply circuit 1a. Accordingly, in the embodiment considered, the control circuit 14 may be configured to receive via the communication interface 16 data being indicative of requested values of the currents to be provided by the current supply circuits 12, and the control circuit 14 may generate the control signals CTR accordingly. In various embodiments, the control circuit 14 may also be connected to one or more sensors in order to generate the control signals CTR, such as one or more current sensors configured to monitor the currents generated via the current supply circuits 12, and/or the voltage $V_{REG}$ and/or the temperature of the power supply circuit 1a.

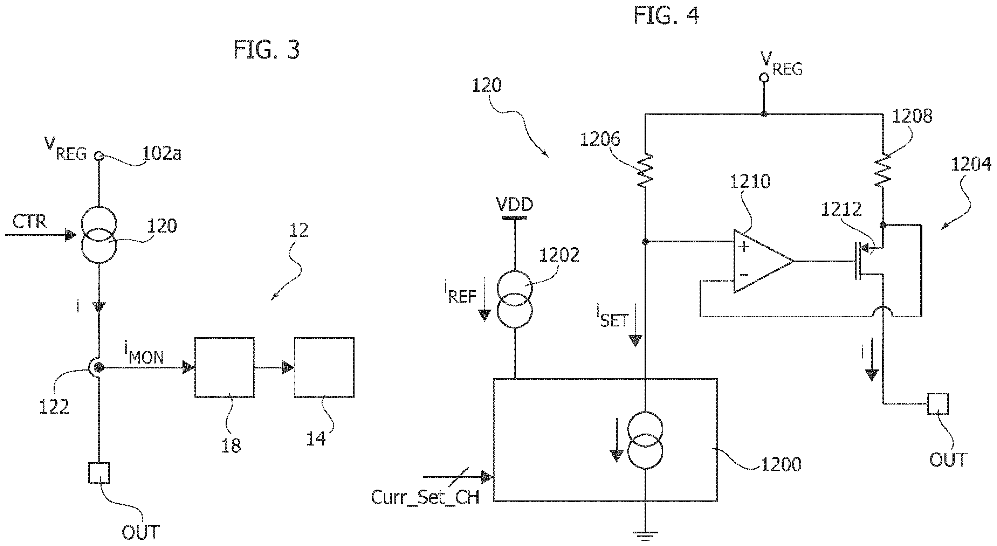

Figure 3 shows an embodiment of current supply circuit 12. In the embodiment considered, the current supply circuit 12 comprises a variable current source 120 connected between the voltage $V_{REG}$ (or the respective voltage $V_{REG}$) and the respective output terminal OUT, wherein the variable current source 120 is configured to provide to the output terminal OUT a current, indicated in Figure 3 as current i. Specifically, in various embodiments, the variable current source 120 is configured to set the value/amplitude of the current $i$ as a function of the control signals CTR.

As mentioned before, various embodiments of the present disclosure relate to solutions for monitoring the currents $i_1$ to $i_k$ provided by the power supply circuit 1a. For example, in the embodiment considered, the power supply circuit 1a comprises a current monitoring circuit 18 and each current supply circuit 12 comprises a current sensor 122 configured to provide a current $i_{MON}$ to the current monitoring circuit 18, wherein the current $i_{MON}$ is proportional to the current $i$ provided by the respective current supply circuit 12. For example, as will be described in greater detail in the following, the current monitoring circuit 18 may determine whether the current $i$, or more specifically the monitored current $i_{MON}$, is between a lower threshold and an upper threshold.

In general, as well-known to those of skill in the art, the intensity of the light emitted by a LED may be varied by varying the average current flowing through the LED. In this respect, the average current flowing through a lighting module 20 may be varied by varying the amplitude of the current $i$ (usually identified as constant current or CC dimming) and/or via a Pulse-Width Modulation (PWM) of the current (usually identified as PWM dimming). Thus, while not shown in the figures, the power supply circuit 1a may also be configured to modulate each current $i_1$ to $i_k$ via a respective PWM modulation, and/or modulate all currents $i_1$ to $i_k$ via a common PWM modulation. For example, in the former case, the variable current source 120 of each current supply circuit 12 may be switched on and off via a respective further control signal CTR corresponding to a PWM signal, thereby implementing an individual PWM modulation of the current $i$ provided to the respective lighting module 20. Conversely, in the latter case, the power supply circuit 1a may comprise an electronic switch configured to selectively connect the current supply circuits 12 and the lighting sources 20 to the voltage $V_{REG}$. For example, in various embodiments, the lighting modules 20 may be connected via a common electronic switch to ground GND and the electronic switch is closed and opened via a further control signal CTR corresponding to a PWM signal, thereby implementing a common PWM dimming of all lighting modules 20, whereby the relative light intensity of the lighting modules may be set via the individual CC dimming via the current generator 120 (i.e., the amplitude of the currents $i_1$ to $i_k$ during the switch-on periods of the PWM modulation) and optionally the additional individual PWM dimming. Generally, such a PWM dimming of the currents $i_1$ to $i_k$ will not be considered specifically in the following, because it is sufficient that the current monitoring circuit 18 is configured to monitor each current $i_1$ to $i_k$ when the respective channel is enabled, i.e., during the switch-on periods of the optional PWM modulation(s).

Figure 4 shows a possible implementation of the variable current source 120. Specifically, in the embodiment considered, the variable current source 120 comprises a Current Digital-to-Analog Converter (IDAC) 1200. As schematically shown in Figure 4, in the embodiment considered, the IDAC 1200 is configured to receive a reference current $i_{REF}$, e.g., provided via a reference current source 1202, e.g., supplied via a DC supply voltage VDD, such as a voltage in a range between 3 and 5 V, and a digital signal Curr_Set_CH indicative of a multiplier c, wherein the multiplier c is an integer number. Moreover, the IDAC 1200 is configured to generate a current $i_{SET}$ corresponding to a multiple of the reference current $i_{REF}$ according to the multiplier $c$ set via the signal Curr_Set_CH, i.e., $i_{SET} = c \cdot i_{REF}$. For example, in various embodiments, the signal Curr_Set_CH has 8 bits, which permits to set the current $i_{SET}$ in a range between 0 and $255 \cdot I_{REF}$. However, the signal Curr_Set_CH may also have less bits or more bits. For example, as well known in the art, such an IDAC may be implemented with a plurality of current mirrors having different mirroring ratios, and wherein the current mirrors are selectively enabled as a function of the bits of the signal Curr_Set_CH.

In various embodiments, the current source 120 comprises a circuit 1204 for applying a scaled version of the current $i_{SET}$ to the respective output terminal OUT, i.e., $i = m \cdot i_{SET}$, wherein $m$ represents a scaling factor. For example, in various embodiments, the circuit 1204 is implemented via a current mirror.

Conversely, in the embodiment shown in Figure 4, the circuit 1204 comprises a first resistance 1206 connected between the voltage $V_{REG}$ and the output of the IDAC 1200. Accordingly, in the embodiment considered, the current $i_{SET}$ flows through the resistance 1206 and generates a voltage drop at the resistance 1206 being proportional to the current $i_{SET}$ and the resistance value of the resistance 1206.

Moreover, in the embodiment considered, the circuit 1204 comprises a second resistance 1208 connected with (the current path of) a Field-Effect Transistor (FET) 1212, such as a MOSFET, between the voltage $V_{REG}$ and the output terminal OUT. Accordingly, in the embodiment considered, the current $i$ flows through the resistance 1208 and generates a voltage drop being proportional to the current i and the resistance value of the resistance 1208.

Finally, in the embodiment considered, the circuit 1204 comprises an operational amplifier (OpAmp) 1210 configured to drive the gate terminal of the FET 1212, such that the voltage drop at the resistance 1208 corresponds to the voltage drop at the resistance 1206. Accordingly, in the embodiment considered, the FET 1212 essentially acts as a variable current source.

For example, in various embodiments, the FET is a p-channel FET. In this case, a first terminal of the resistance 1208 is connected to the voltage $V_{REG}$, a source terminal of the p-channel FET 1212 is connected to a second terminal of the resistance 1208 and a drain terminal of the p-channel FET 1212 is connected to the output terminal OUT. Moreover, when using a p-channel FET, the positive/noninverting input of the OpAmp 1210 is connected to the intermediate node between the resistance 1206 and the IDAC 1200, and the negative/ inverting input of the OpAmp 1210 is connected to the intermediate node between the resistance 1208 and the FET 1212 (source terminal of the FET 1212), wherein the output terminal of the OpAmp 1210 is connected to the gate terminal of the p-channel FET 1212.

Accordingly, in the steady state condition, the voltage drop at the resistance 1208 corresponds to the voltage drop at the resistance 1206. Accordingly, in order to obtain a scaled current $i = m \cdot i_{SET}$, the resistance 1206 has a resistance value corresponding to the resistance value of the resistance 1208 multiplied by $m$. For example, when indicating the resistance value of the resistance 1208 as $Rs$, the resistance 1206 has a resistance value of $m \cdot Rs$. For example, the scaling factor $m$ may be selected in a range between 5 and 100, e.g., between 10 and 30, e.g., $m = 20$. In various embodiments, the resistances 1206 and 1208 are matched resistances, which ensures that the resistances 1206 and 1208 are subject to the same process, voltage, and temperature (PVT) variations. For example, in various embodiments, resistances 1206 and 1208 are arranged in close proximity within the IC of the power supply circuit 1a.

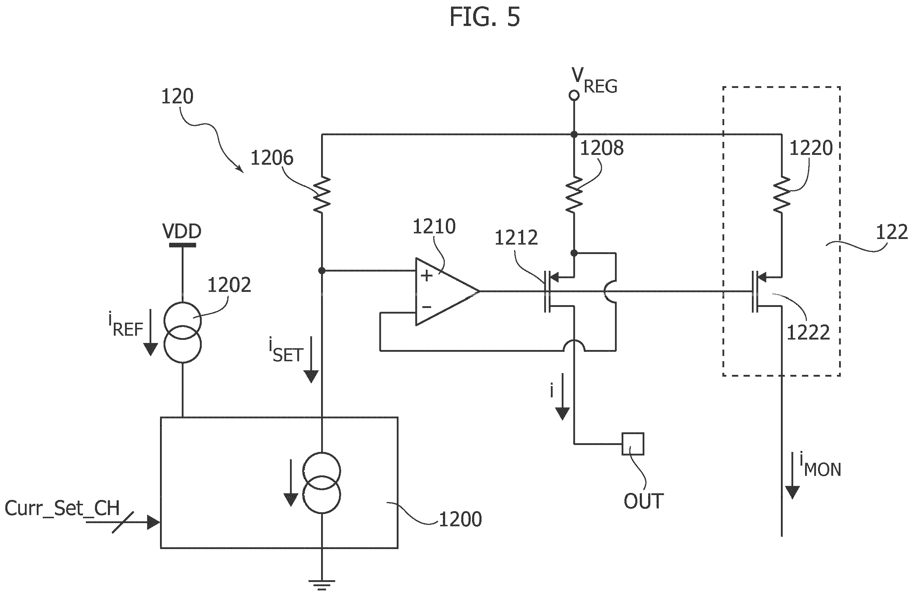

Figure 5 shows in this respect a possible implementation of the current sensor 122, when using the variable current source 120 described with respect to Figure 4. Specifically, as described in the foregoing, the current $i$ flows also through the FET 1212. Accordingly, in order to implement the current sensor 122, it is sufficient that the current supply circuit 12 comprises a further branch comprising a further resistance 1220 and a further FET 1222 of the same type (n-channel or p-channel) as the FET 1212, wherein the gate terminal of the FET 1222 is connected to the gate terminal of the FET 1212. For example, in the embodiment considered, the FET 1222 is a p-channel FET, wherein the source terminal of the FET 1222 is connected via the resistance 1220 to the voltage $V_{REG}$, the gate terminal of the FET 1222 is connected to the gate terminal of the FET 1212 and the drain terminal of the FET 1222 provides the measurement current $i_{MON}$.

Accordingly, in the embodiment considered, in order to obtain a scaled current $i_{MON} = i/p$, the resistance 1220 has a resistance value corresponding to the resistance value of the resistance 1208 multiplied by $p$, i.e., the resistance 1220 has a resistance value of $p \cdot Rs$. Preferably, also the FET 1222 corresponds to a scaled version of the FET 1212, e.g., the FET 1222 has a width-to-length (W/L) ratio corresponding to the ratio W/L of the FET 1212 divided by the scaling factor $p$. In various embodiments, the resistances 1220 and 1208 are matched resistances, which ensures that the resistances 1220 and 1208 are subject to the same process, voltage, and temperature (PVT) variations. For example, in various embodiments, resistances 1206, 1208 and 1220 are arranged in close proximity within the IC of the power supply circuit 1a. As will be described in greater detail in the following, in various embodiments, the scaling factor $p$ corresponds to the scaling factor m, i.e., $p = m$.

Similarly, when using a current mirror 1204, the current mirror 1204 may comprise an additional (output) branch providing the measurement current $i_{MON}$. For example, such a current mirror 1204 may be implemented with three p-channel FETs having their source terminals connected to the voltage $V_{REG}$, wherein the drain terminal of the first FET is connected to the output of the IDAC 1200, the drain terminal of the second FET provides the current i to the output OUT, the drain terminal of the third FET provides the measurement current $i_{MON}$, and the gate terminals of the three FETs are connected to the drain terminal of the first FET (output of the IDAC 1200). Specifically, in this case, the scaling factor $m$ corresponds to the scaling between the second FET and the first FET, and the scaling factor p corresponds to the scaling between the third FET and the second FET, wherein also in this case, the scaling factors preferably correspond, i.e., $p = m$.

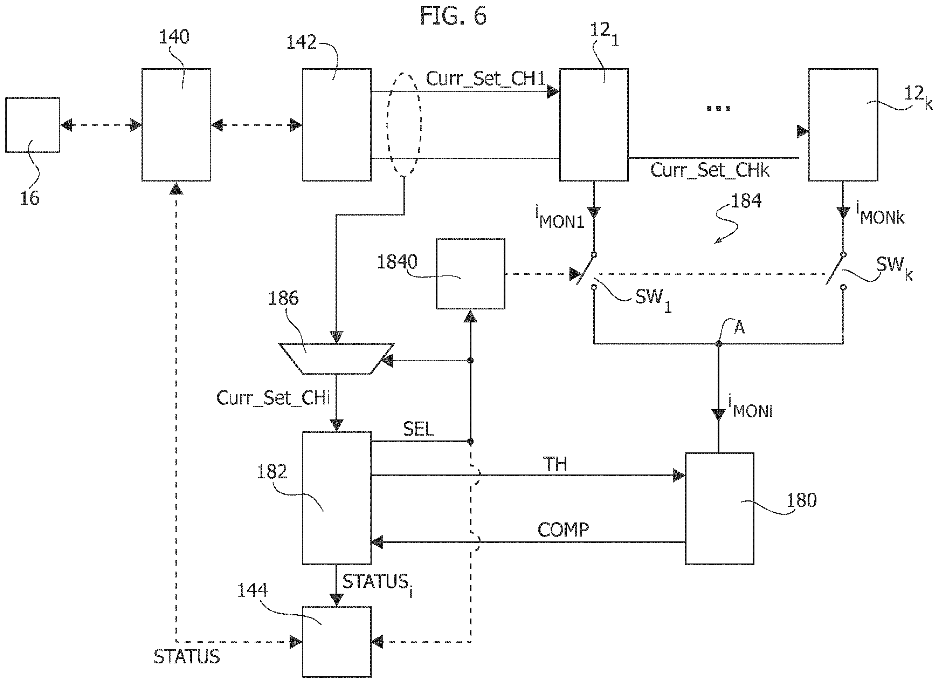

Figure 6 shows an embodiment of the current monitoring circuit 18. Specifically, as mentioned before, in various embodiments, the current monitoring circuit 18 is configured to determine whether the currents $i_1$ to $i_k$ are within given expected thresholds, wherein the values of the currents $i_1$ to $i_k$ are set via the respective signal Curr_Set_CH provided to each current supply circuit 12, which are indicated in the following as signals Curr_Set_CH1 to Curr_Set_CHk, e.g., the current supply circuit $12_1$ sets the current $i_1$ based on the signal Curr_Set_CH1.

For example, in the embodiment considered, the control circuit 14 of the power supply circuit 1a comprises a plurality of registers 142 for storing the values of the signals Curr_Set_CH1 to Curr_Set_CHk.

As mentioned before, in various embodiments, the values of the signals Curr_Set_CH1 to Curr_Set _CHk may be programmed by the control circuit 14. For example, in Figure 6 is shown a processing circuit 140 of the control circuit 14 configured to program/write the content of the registers 142. For example, as mentioned before, in various embodiments, the control circuit 14, e.g., the processing circuit 140, may receive the values of the signals Curr_Set_CH1 to Curr_Set_CHk via a communication interface 16. In general, any suitable communication protocol may be used for receiving programming commands via the communication interface 16, such as:

- a programming command comprising the value of one of the signals Curr_Set_CH1 to Curr_Set_CHk, e.g., comprising an address of the register 142 associated with a respective signal Curr_Set_CH1 to Curr_Set_CHk and the respective value for the signal Curr_Set_CH1 to Curr_Set_CHk; and/or
- a programming command comprising the values of all signals Curr_Set_CH1 to Curr_Set_CHk, e.g., comprising a data packet comprising in sequence the values for the signals Curr_Set_CH1 to Curr_Set_CHk; and/or
- a programming command comprising a subset of the values of the signals Curr_Set_CH1 to Curr_Set_CHk.

Additionally or alternatively, the processing circuit 140 may vary the values of the signals Curr_Set_CH1 to Curr_Set_CHk as a function of data provided by one or more sensors of the power supply circuit 1a, such as data indicative of the value of the voltage $V_{REG}$ and/or data indicative of the temperature of one or more components of the power supply system 1a, such as the temperatures of the current supply circuits 12.

In the embodiment considered, the current monitoring circuit 18 comprises a multiplexer 184 configured to generate a current $i_{MONi}$ by selecting one of the currents $i_{MON1}$ to $i_{MONk}$ as a function of a selection signal SEL generated by a (digital) control circuit 182 of the current monitoring circuit 18. For example, in the embodiment considered, the multiplexer 184 comprises $k$ electronic switches $SW_1$ to $SW_k$, wherein each electronic switch $SW_1$ to $SW_k$ is connected between a respective current supply circuit and a node A. Accordingly, in this case each electronic switch $SW_1$ to $SW_k$ is configured to provide the respective current $i_{MON1}$ to $i_{MONk}$ to the node A when the electronic switch $SW_1$ to $SW_k$ is closed and the node A provides a current $i_{MONi}$, corresponding to the sum of the respective current $i_{MON1}$ to $i_{MONk}$ for which the respective electronic switch $SW_1$ to $SW_k$ is closed. Accordingly, in the embodiments considered, the multiplexer 184 may comprise a decoder 1840 configured to close one of the electronic switches $SW_1$ to $SW_k$ as a function of the selection signal SEL, whereby the node A provides a current $i_{MONi}$, corresponding to one of the current $i_{MON1}$ to $i_{MONk}$. Accordingly, in the embodiment considered, the selection signal SEL may be used to select one of the channels of the power supply circuit.

Accordingly, in various embodiments, the control circuit 182 is configured to generate the selection signal SEL in order to sequentially select the signals $i_{MON1}$ to $i_{MONk}$ (in any suitable order), and the current monitoring circuit 18 is configured to verify whether the selected current $i_{MONi}$ is within an expected value range, wherein the expected value range is determined as a function of the respective value Curr_Set_CH1 to Curr_Set_CHk associated with the selected current $i_{MON1}$ to $i_{MONk}$.

In general, the current monitoring circuit 18 could comprise an analog-to-digital converter (ADC) and the current monitoring circuit 18 could be configured to obtain a digital sample of the value of the selected current $i_{MONi}$ and verify whether the digital sample is within the expected value range determined as a function of the respective value Curr_Set_CH1 to Curr_Set_CHk. However, as mentioned before, also a significant number of currents $i_{MON1}$ to $i_{MONk}$ may be generated. Accordingly, performing an AD conversion may not be feasible in many application scenarios, wherein a fast detection of abnormal conditions is required. Accordingly, in order to increase the speed of the verification operation, the current monitoring circuit 18 could comprise a plurality of ADCs in order to sample in parallel a plurality of currents $i_{MON1}$ to $i_{MONk}$. However, such ADCs are complex, which would increase the dimension and cost of the power supply circuit.

Accordingly, in the following will be described a solution, wherein the current monitoring circuit 18 is configured to verify the value of the selected current $i_{MONi}$ in analog.

Specifically, in various embodiments, the selected current $i_{MONi}$ is provided to a current comparison circuit 180. The current comparison circuit 180 receives also one or more threshold control signals TH indicative of a comparison threshold $i_{TH}$ and is configured to generate a comparison signal COMP by comparing the selected current $i_{MONi}$ with the comparison threshold $i_{TH}$. For example, in various embodiments, the comparison circuit 180 is configured to assert, e.g., set to high, the comparison signal COMP when the current $i_{MONi}$ is smaller than the comparison threshold $i_{TH}$, i.e., $i_{MONi} < i_{TH}$, and de-assert, e.g., set to low, the comparison signal COMP when the current $i_{MONi}$ is greater than the comparison threshold $i_{TH}$, i.e., $i_{MONi} > i_{TH}$.

In this respect, as described in the foregoing, in various embodiments, the current $i$ provided by a current supply circuit corresponds to $i = m \cdot i_{SET}$, with $i_{SET} = c \cdot i_{REF}$, i.e.:

$$i = m \cdot c \cdot i_{REF} \tag{1}$$

wherein $m$ is a constant scaling (or in general proportionality) factor of the variable current source 120 and the multiplier $c$ is set via the signal Curr_Set_CH.

Moreover, the measurement current corresponds to $i_{MON} = i/p$, which may be reformulated according to equation (1):

$$i_{MON} = m/p \cdot c \cdot i_{REF} \tag{2}$$

where $p$ is a constant scaling (or in general proportionality) factor of the current sensor 122, i.e., the ratio $m/p$ is fixed. In this respect, by selecting a scaling factor $p$ corresponding to the scaling facto $m$, i.e., $p = m$, equation (2) may be simplified as follows:

$$i_{MON} = c \cdot i_{REF} \tag{3}$$

Accordingly, equations (2) or (3) indicate the expected value $i_{MON,exp}$ for the current $i_{MON}$ for a given signal Curr_Set_CH. Equations (2) or (3) thus also apply to the expected value $i_{MONi,exp}$ for the selected current $i_{MONi}$, wherein the expected value $i_{MONi,exp}$ may be calculated based on the respective signal Curr_Set_CHi. For example, as shown in Figure 6, the current monitoring circuit 18 may comprise a multiplexer 186 configured to generate the signal Curr_Set_CHi by selecting the signal Curr_Set_CH1 to Curr_Set_CHk associated with the selected channel/the selected current $i_{MONi}$.

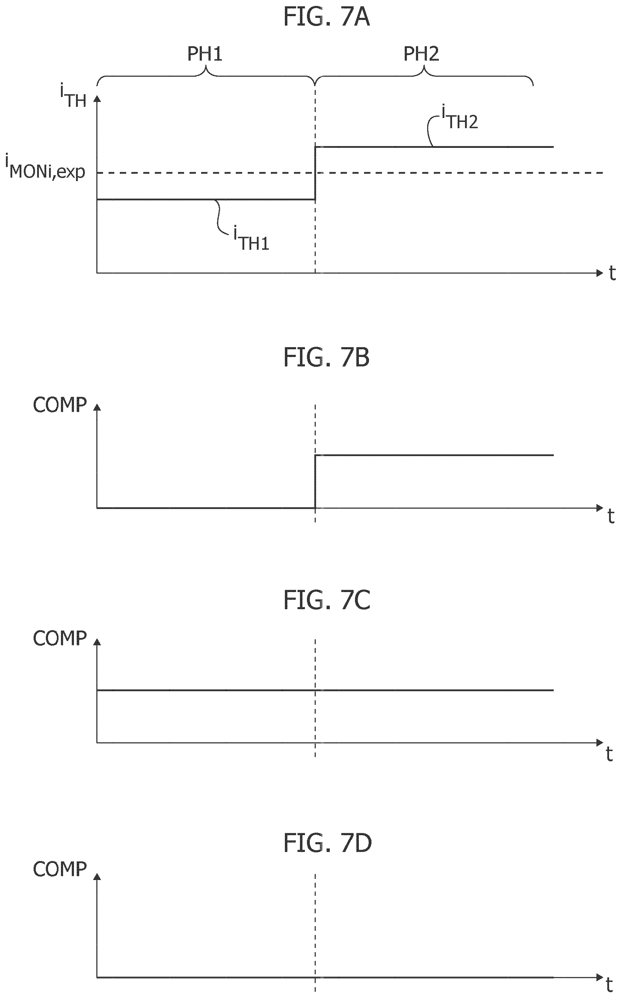

In this respect, as shown in Figure 7A, in various embodiments, the control circuit 182 receives the signal Curr_Set_CHi and generates the one or more signals TH in order to:

- in a first phase PH1, set the comparison threshold $i_{TH}$ to a first value $i_{TH1}$ being smaller than the expected value $i_{MONi,exp}$ (as indicated by the signal Curr_Set_CHi) by a given first amount, e.g., $i_{TH1} = i_{MON,exp} - (x \cdot i_{MON,exp})$, where $x$ indicates a tolerance range for the expected value $i_{MON,exp}$ and may be selected, e.g., in the range between 0.05 and 0.3, preferably between 0.1 and 0.25, e.g. $x = 0.20$; and
- in a second phase PH2, set the comparison threshold $i_{TH}$ to a second value $i_{TH2}$ being greater than the expected value $i_{MONi,exp}$ (as indicated by the signal Curr_Set_CHi) by a given second amount, e.g., $i_{TH2} = i_{MON,exp} + (x \cdot i_{MON,exp})$.

In general, the sequence of phases may also be inverted. Moreover, instead of using a tolerance range, the first amount and the second amount may be fixed or predetermined, e.g., programmable via the communication interface 16. Similarly, in various embodiments, the tolerance value $x$ may be programmable via the communication interface 16.

Accordingly, as shown in Figure 7B, in various embodiments, when the monitored current $i_{MONi}$ has (approximately) the expected value $i_{MONi,exp}$, the comparison circuit 180 de-asserts the comparison signal COMP during the phase PH1, because the current $i_{MONi}$ is greater than the comparison threshold $i_{TH}$, i.e., $i_{MONi} > i_{TH1}$, and asserts the comparison signal COMP during the phase PH2, because the current $i_{MONi}$ is smaller than the comparison threshold $i_{TH}$, i.e., $i_{MONi} < i_{TH2}$.

Conversely, as shown in Figure 7C, in various embodiments, when the monitored current $i_{MONi}$ is (significantly) smaller than the expected value $i_{MONi,exp}$, the comparison circuit 180 asserts the comparison signal COMP both during the phase PH1 and the phase PH2, because the current $i_{MONi}$ is always smaller than the comparison threshold $i_{TH}$, i.e., $i_{MONi} < i_{TH1}$ and $i_{MONi} < i_{TH2}$.

Conversely, as shown in Figure 7D, in various embodiments, when the monitored current $i_{MONi}$ is (significantly) greater than the expected value $i_{MONi,exp}$, the comparison circuit 180 de-asserts the comparison signal COMP both during the phase PH1 and the phase PH2, because the current $i_{MONi}$ is always greater than the comparison threshold $i_{TH}$, i.e., $i_{MONi} > i_{TH1}$ and $i_{MONi} > i_{TH2}$.

Accordingly, in various embodiments, the control circuit 182 generates the one or more threshold control signals TH in order to vary the threshold current $i_{TH}$ as indicated in the foregoing, and verifies whether the comparison signal COMP is de-asserted in the phase PH1 and asserted in the phase PH2. In this respect, in various embodiments, the control circuit 182 is configured to:

- assert, e.g., set to high, a status signal STATUSi, in response to determining that the comparison signal COMP is de-asserted in the phase PH1 and asserted in the phase PH2; and
- de-assert, e.g., set to low, the status signal STATUSi, in response to determining that the comparison signal COMP is asserted in the phase PH1 or de-asserted in the phase PH2.

In various embodiments, the same operation could be obtained by performing the comparison in parallel via two comparison circuits 180, wherein the first comparison circuit 180 is configured to compare the current $i_{MONi}$ with the threshold $i_{TH1}$, and the second comparison circuit 180 is configured to compare the current $i_{MONi}$, with the threshold $i_{TH2}$. However, in this case, the control circuit 182 generates in parallel two threshold signals TH, i.e., a first threshold signal TH for setting the current $i_{TH1}$ and a second threshold signal TH for setting the current $i_{TH2}$. In this respect, the solution shown in Figure 6 requires just one comparison circuit 180 and has thus a reduced complexity and cost.

In various embodiments, the control circuit 14 of the power supply circuit 1a may comprise a register 144 and the value of the status signal STATUSi may be stored to a respective bit position associated with the channel selected via the selection signal SEL. For example, this is schematically shown in Figure 6, wherein the selection signal SEL is used to select a bit position in the register 144 for storing the value of the status signal STATUSi. Accordingly, in the embodiment considered, the control circuit 182 may (e.g., periodically) scan all channels, whereby the register 144 provides a status signal STATUS indicating the status of all channels OUT1 to OUTk.

In this respect, in various embodiments, instead of scanning all channels, the control circuit 182 may sequentially select (via the selection signal SEL) only a subset of the channels.

For example, in various embodiments, the control circuit 182 may just select the channels for which the value of the signals Curr_Set_CH1 to Curr_Set_CHk is different from 0.

Alternatively, in various embodiments, the control circuit 14 may also comprise a register for storing channel enable flags, which indicate for each current supply circuit 12 whether the respective current source 120 should be enabled. Accordingly, in this case, the control circuit 182 may just select the channels for which the respective channel enable flag indicates that the respective current source 120 is enabled. For example, such channel enable flags may be stored to the register 142 and may be used to generate for each current supply circuit 12 a further control signal CTR indicating whether the respective current source 120 should be enabled. In various embodiments, the channel enable flags may be programmable via the communication interface 16.

Alternatively, in various embodiments, the control circuit 14 may also comprise a register for storing channel monitoring flags, which indicate for each channel whether the respective channel should be monitored. Accordingly, in this case, the control circuit 182 may just select the channels for which the respective channel monitoring flag indicates that the respective channel should be monitored. For example, such channel monitoring flags may be stored to the register 144. In various embodiments, the channel monitoring flags may be programmable via the communication interface 16.

In the following will now be described possible embodiments of the comparison circuit 180 and the respective generation of the one or more threshold control signals TH by the control circuit 182. As described in the foregoing, in various embodiments, the current comparison circuit 180 receives the selected current $i_{MONi}$ and one or more threshold control signals TH indicative of the comparison threshold $i_{TH}$ and is configured to generate a comparison signal COMP by comparing the selected current $i_{MONi}$ with the comparison threshold $i_{TH}$. Accordingly, in various embodiments, the comparison circuit 180 is configured to generate the comparison threshold $i_{TH}$ as a function of the one or more threshold control signals TH.

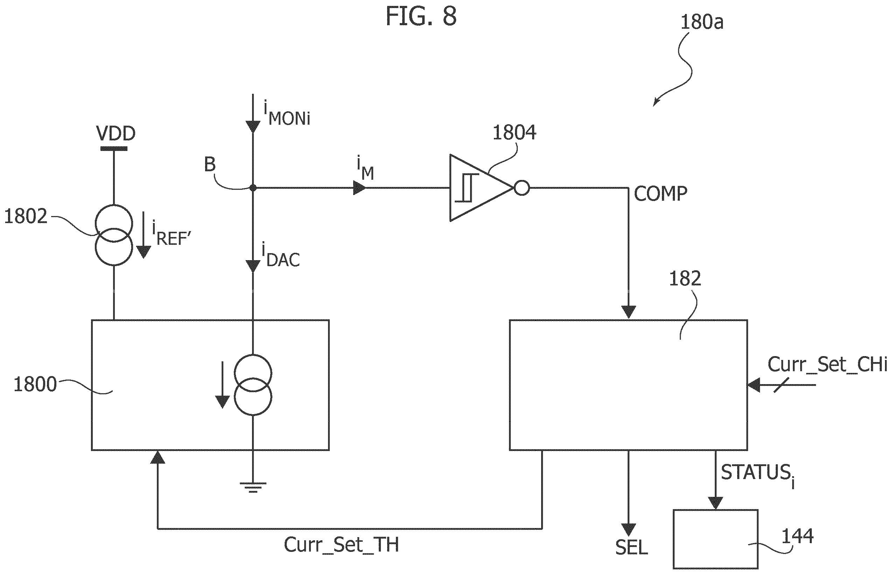

Figure 8 shows a first embodiment of the comparison circuit 180, indicated as comparison circuit 180a, wherein the comparison circuit 180a comprises an IDAC 1800. As schematically shown in Figure 8, in the embodiment considered, the IDAC 1800 is configured to receive a reference current $i_{REF}'$, e.g., provided via a reference current source 1802, e.g., supplied via the DC supply voltage VDD and a digital signal Curr_Set_TH indicative of a multiplier $q$, wherein the multiplier $q$ is an integer number. Moreover, the IDAC 1800 is configured to generate a current $i_{DAC}$ corresponding to a multiple of the reference current $i_{REF}'$ according to the multiplier $q$ set via the signal Curr_Set_TH, i.e., $i_{DAC} = q \cdot i_{REF}'$. For example, in various embodiments, the signal Curr_Set_TH has 8 bits, which permits to set the current $i_{DAC}$ in a range between 0 and $255 \cdot i_{REF}'$.

Specifically, as described with respect to equation (2), the monitored current corresponds to $i_{MON} = m/p \cdot c \cdot i_{REF}$. Accordingly, in various embodiments, the reference current $i_{REF}'$ is selected as:

$$i_{REF}' = m/p \cdot i_{REF}. \tag{4}$$

For example, in various embodiments, the scaling factors $m$ and $p$ are designed such that $m/p = 1$, i.e., the reference current $i_{REF}'$ corresponds to the reference current $i_{REF}$, i.e., $i_{REF}' = i_{REF}$.

Accordingly, in various embodiments, the IDAC 1800 provides the following current:

$$i_{DAC} = q \cdot m/p \cdot i_{REF}. \tag{5}$$

In fact, in this way, the IDAC 1800 is configured to provide a current $i_{DAC}$ corresponding to the expected current $i_{MONi,exp}$, i.e., $i_{DAC} = i_{MONi,exp}$, when the signal Curr_Set_TH corresponds to the signal Curr_Set_CHi of the currently selected channel, i.e., when $q = c$.

In the embodiment considered, the current $i_{MONi}$ is provided to a node B, and the IDAC 1800 is configured to sink the current $i_{DAC}$ from the node B, i.e., the node B provides a current $i_M = i_{MONi} - i_{DAC}$. Moreover, the node B is connected to a current comparator 1804, i.e., the current comparator 1804 receives the current $i_M$. Moreover, the current comparator 1804 is configured to:

- assert, e.g., set to high, the comparison signal COMP, when the current $i_M$ is smaller than zero;
- de-assert, e.g., set to low, the comparison signal COMP, when the current $i_M$ is greater than zero.

Thus, in the embodiments considered, the operation of the comparator 1804 is inverted with respect to a conventional current comparator, which is schematically shown via the inverting "dot" at the output of the comparator 1804.

Accordingly, in the embodiment considered, in order to generate the currents $i_{TH} = i_{TH1}$ and $i_{TH} = i_{TH2}$ described with respect to Figures 6 and 7, the control circuit 182 may be configured to:

- in the first phase PH1, set the value of the signal Curr_Set_TH to a first value Curr_Set_TH1 being smaller than the value Curr_Set_CHi (which indicates the expected value $i_{MONi,exp}$) by a given first amount, e.g., Curr_Set_TH1 = Curr_Set_CHi - ($x \cdot$ Curr_Set_CHi), where $x$ indicates the previously described tolerance range for the expected value $i_{MON,exp}$; and
- in the second phase PH2, set the value of the signal Curr_Set_TH to a second value Curr_Set_TH2 being greater than the value Curr_Set_CHi by a given second amount, e.g., Curr_Set_TH2 = Curr_Set_CHi + ($x \cdot$ Curr_Set_CHi).

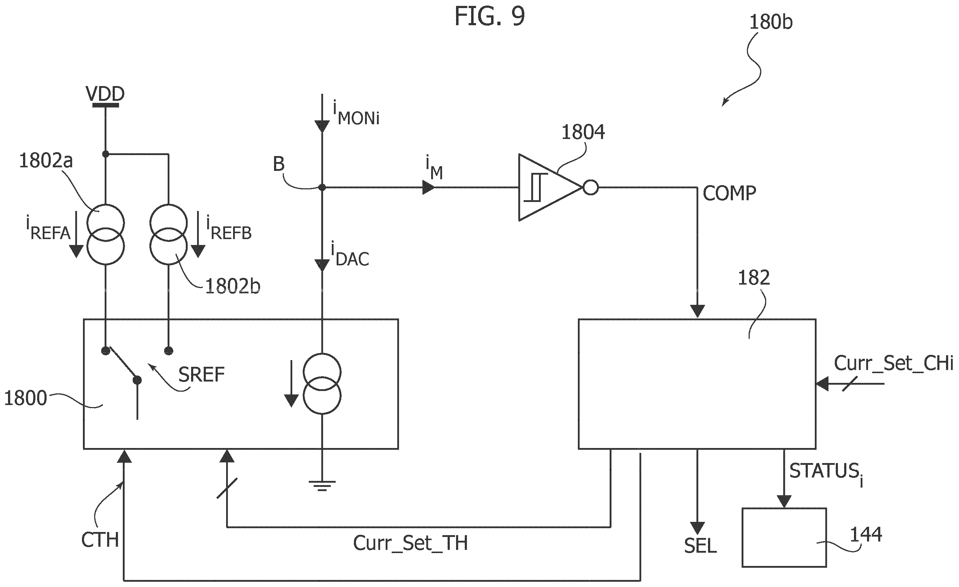

Figure 9 shows a second embodiment of the comparison circuit 180, indicated as comparison circuit 180b. Specifically, in the embodiment considered, the control circuit 182 is configured to set, both during the first phase PH1 and the second phase, the value of the signal Curr_Set_TH to the value Curr_Set_CHi. Conversely, in order to generate the currents $i_{TH} = i_{TH1}$ and $i_{TH} = i_{TH2}$, the control circuit 182 may be configured to:

- in the first phase PH1, set the value of the reference current $i_{REF}'$ to a first value $i_{REFA}$ being smaller than the reference current $i_{REF}$ by a given first amount, e.g., $i_{REFA} = i_{REF} - (x \cdot i_{REF})$, where x indicates the previously described tolerance range for the expected value $i_{MON,exp}$; and
- in the second phase PH2, set the value of the reference current $i_{REF}'$ to a second value $i_{REFB}$ being greater than the reference current $i_{REF}$ by a given second amount, e.g., $i_{REFB} = i_{REF} + (x \cdot i_{REF})$.

As described with respect to equation (4), the current $i_{REF}$ may indeed be replaced with $m/p \cdot i_{REF}$ when the factor $m$ does not correspond to the factor $p$.

For example, in order to vary the reference current $i_{REF}'$, the current comparison circuit 180b may comprise indeed two reference current sources 1802a and 1802b configured to generate the currents $i_{REFA}$ and $i_{REFB}$, respectively, and a switching circuit SERF configured to provide to the IDAC 1800 as reference current $i_{REF}'$ either the current $i_{REFA}$ or the current $i_{REB}$ as a function of a selection signal CTH. According, in the embodiment considered, the control circuit 182 is configured to generate also the control signal CTH in order to:

- in the first phase PH1, provide the reference current $i_{REFA}$ to the IDAC 1800, e.g., by setting the signal CTH to low; and
- in the second phase PH2, provide the reference current $i_{REFB}$ to the IDAC 1800, e.g., by setting the signal CTH to high.

Accordingly, in the embodiment shown in Figure 9, the signals Curr_Set_TH and CTH represent the threshold control signals TH generated by the control circuit 182.

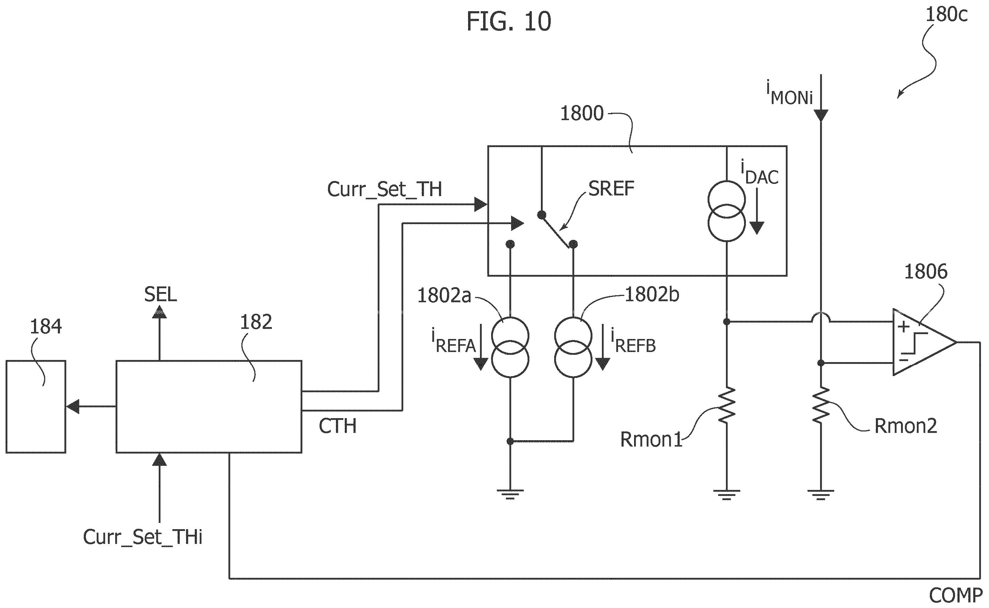

Figure 10 shows a third embodiment of the comparison circuit 180, indicated as comparison circuit 180c. Specifically, in the embodiment considered, instead of using a current comparator 1804, the comparison circuit 180c comprises a voltage comparator 1806 configured to compare a first voltage with a second voltage.

Specifically, in the embodiment considered, the control circuit 182 and the IDAC 1800 are again configured to generate during the first phase PH1 a current $i_{DAC} = i_{TH1}$ and during the second phase PH2 a current $i_{DAC} = i_{TH2}$. For example, in Figure 10 is used the solution described with respect to Figure 9 (the digital input Curr_Set _TH remains unchanged and the reference current $i_{REF}$' is changed), but also the solution of Figure 8 may be used (the reference current $i_{REF}$' remains unchanged and the digital input Curr_Set_TH is changed).

In the embodiment considered, the current monitoring circuit 180c comprises moreover two resistances Rmon1 and Rmon2, such as resistors, wherein the current $i_{DAC}$ flows through the resistance Rmon1, thereby generating a first voltage, and the current $i_{MONi}$ flows through the resistance Rmon2, thereby generating a second voltage. In the embodiment considered, the resistances Rmon1 and Rmon2 have the same resistance value and are preferably matched resistors. Accordingly, in the embodiment considered, the voltage comparator 1806 may receive at the positive input terminal the voltage (drop) at the resistance Rmon1 and at the negative input terminal the voltage (drop) at the resistance Rmon2, whereby the comparator 1806:

- asserts, e.g., sets to high, the comparison signal COMP, when the current $i_{DAC}$ is greater than the voltage $i_{MONi}$ (which is usually the case during the second phase PH2).
- de-asserts, e.g., sets to low, the comparison signal COMP, when the current $i_{DAC}$ is smaller than the voltage $i_{MONi}$ (which is usually the case during the first phase PH1).

As mentioned before, the measurement circuit 18 could also comprise two comparison circuits 180, which operate in parallel with respective threshold values. However, since the comparison circuits 180 shown in Figures 8, 9 and 10 comprises an IDAC 1800, the complexity of the measurement circuit 18 would be increased significantly.

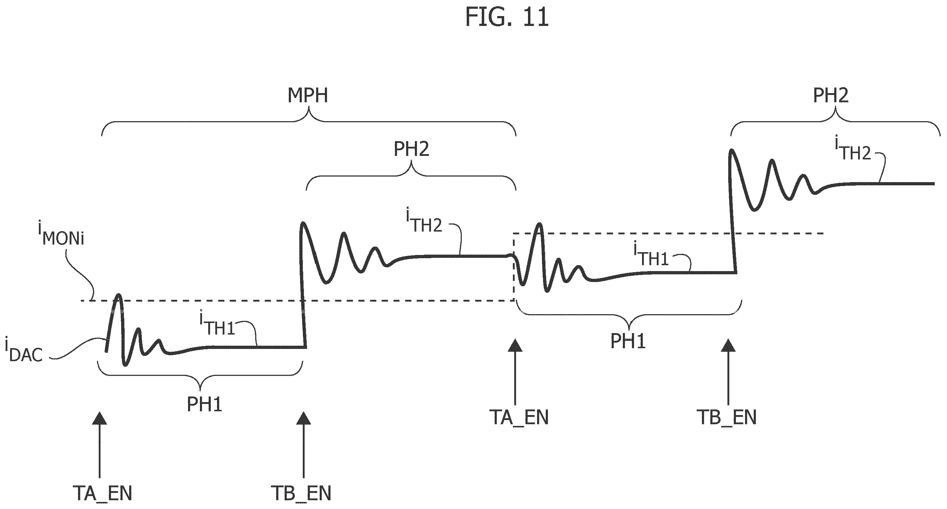

Figure 11 shows an embodiment of the waveform of the current $i_{DAC}$ generated by the IDAC 1800. Specifically, in the embodiments described in the foregoing, the control circuit 182 receives the signal Curr_Set_CHi (indicative of the current $i_{MONi}$) and sets the one or more signals TH, such as the signal Curr_Set _TH and optionally the signal CTH, in order to set a first current $i_{TH1}$ during the first phase PH1 and a second current $i_{TH2}$ during the second phase PH2. For example, in various embodiments, the control circuit 182 comprises a timer circuit configured to generate one or more signals indicating the first phase PH1 and the second phase PH2, such as a first signal TA_EN indicating the start of a new first phase PH1 and a second signal TB_EN indicating the start of a new second phase PH2. For example, in various embodiments, the control circuit 182 is configured to:

- in response to detecting that the signal TA_EN is asserted, set the one or more signals TH as a function of the value Curr_Set_CHi in order to generate a current $i_{DAC}$ corresponding to the value $i_{TH1}$; and
- in response to detecting that the signal TB_EN is asserted, set the one or more signal TH as a function of the value Curr_Set_CHi in order to generate a current $i_{DAC}$ corresponding to the value $i_{TH2}$.

Moreover, in various embodiments, the control circuit changes the selection signal SEL at the beginning of each measurement cycle MPH (comprising the phases PH1 and PH2), e.g., in response to detecting the start of a first phase PH1 or end of a second phase PH2.

However, as shown in Figure 11, based on the implementation of the IDAC 1080, once the reference current $i_{REF}$' or the digital input Curr_Set_TH is changed, the output $i_{DAC}$ may not be stable immediately, but a given time, such as few microseconds (μs), may be required until the output $i_{DAC}$ reaches the requested value, i.e., the current $i_{TH1}$ or $i_{TH2}$. Accordingly, in various embodiments, the control circuit 182 is configured to not sample the comparison signal COMP immediately, but after a given predetermined time (e.g., signals via a sampling request signal generated by the timer circuit of the control circuit 182). Alternatively, the control circuit 182 may sample the signal COMP at the end of the of the respective phase. Accordingly, in various embodiments, the control circuit 182 may be configured to sample the comparison signal COMP after a sampling time, for example being greater than 1 μs, e.g., selected in a range between 2 μs and 200 μs, e.g., between 5 μs and 50 μs, e.g., between 10 μs and 30 μs. Accordingly, in various embodiments, each phase may have a period having the same duration or a longer duration as the sampling time. For example, in various embodiments, the control circuit 182 is configured to:

- in response to detecting an instant when the signal TB_EN becomes asserted, sample the signal COMP for the first phase PH1 (which should be de-asserted); and
- in response to detecting an instant when the signal TA_EN becomes asserted, sample the signal COMP for the second phase PH2 (which should be asserted);

Of course, without prejudice to the principle of the invention, the details of construction and the embodiments may vary widely with respect to what has been described and illustrated herein purely by way of example, without thereby departing from the scope of the present invention, as defined by the ensuing claims.

**Claims**

1. A power supply circuit (1a) comprising:

   - a plurality of output terminals ($OUT_1$-$OUT_k$);
   - for each output terminal ($OUT_1$-$OUT_k$) a respective current supply circuit ($12_1$-$12_k$), wherein each current supply circuit ($12_1$-$12_k$) is configured to provide an output current ($i_1$-$i_k$) to the respective output terminal ($OUT_1$-$OUT_k$) as a function of a respective first digital control signal (Curr_Set_CH1-Curr_Set_CHk), and wherein each current supply circuit ($12_1$-$12_k$) comprises a current sensor (122) configured to provide a measurement current ($i_{MON1}$-$i_{MONk}$) being proportional to the respective output current ($i_1$-$i_k$);
   - a first multiplexer circuit (184) configured to provide a selected measurement current ($i_{MONi}$) by selecting one of the measurement currents ($i_{MON1}$-$i_{MONk}$) as a function of a selection signal (SEL) indicating a selected current supply circuit ($12_1$-$12_k$);

   **characterized in that** said power supply circuit (1a) further comprises:

   - a second multiplexer circuit (186) configured to provide a selected digital control signal (Curr_Set_CHi) by selecting one of the first digital control signals (Curr_Set_CH1-Curr_Set_CHk) as a function of said selection signal (SEL) indicating a selected current supply circuit ($12_1$-$12_k$);
   - a comparison circuit (180) configured to:

      - generate a threshold current ($i_{TH}$) as a function of one or more digital threshold control signals (TH),
      - compare the selected measurement current ($i_{MONi}$) with said threshold current ($i_{TH}$),
      - in response to determining that said selected measurement current ($i_{MONi}$) is greater than said threshold current ($i_{TH}$), de-assert a comparison signal (COMP), and
      - in response to determining that said selected measurement current ($i_{MONi}$) is smaller than said threshold current ($i_{TH}$), assert said comparison signal (COMP);

   - a control circuit (182) configured to repeat the following operations periodically:

      - generate said selection signal (SEL) in order to select a measurement current ($i_{MONi}$) and a first digital control signal (Curr_Set_CHi) associated with a given current supply circuit ($12_1$-$12_k$);
      - generate said one or more digital threshold control signals (TH) as a function of said selected digital control signal (Curr_Set_CHi) in order to:

         - during a first phase (PH1), set via said comparison circuit (180) said threshold current ($i_{TH}$) to a first value ($i_{TH1}$), said first value ($i_{TH1}$) being smaller than an expected value ($i_{MONi,exp}$) for said selected measurement current ($i_{MONi}$) as indicated by said selected digital control signal (Curr_Set_CHi), and
         - during a second phase (PH2), set via said comparison circuit (180) said threshold current ($i_{TH}$) to a second value ($i_{TH2}$), said second value ($i_{TH2}$) being greater than said expected value ($i_{MONi,exp}$) for said selected measurement current ($i_{MONi}$) as indicated by said selected digital control signal (Curr_Set_CHi),

      - verify whether said comparison signal (COMP) is de-asserted during said first phase (PH1) and asserted during said second phase (PH2),
      - in response to determining that said comparison signal (COMP) is de-asserted during said first phase (PH1) and asserted during said second phase (PH2), assert a status signal (STATUSi), and
      - in response to determining that said comparison signal (COMP) is asserted during said first phase (PH1) or de-asserted during said second phase (PH2), de-assert said status signal (STATUSi).

2. The power supply circuit according to Claim 1, where each current supply circuit ($12_1$-$12_k$) comprises:

   - a current digital-to-analog converter (1200) configured to receive a first reference current ($i_{REF}$) and the respective first digital control signal (Curr_Set_CH1- Curr_Set_CHk), wherein said first digital control signal (Curr_Set_CH1-Curr_Set_CHk) is indicative of a first multiplier, and said current digital-to-analog converter (1200) is configured to generate a first current ($i_{SET}$) by multiplying said first reference current ($i_{REF}$) with said first multiplier; and
   - a scaling circuit (1204) configured to generate said output current ($i_1$-$i_k$) by generating an amplified version of said first current ($i_{SET}$) according to a first scaling factor.

3. The power supply circuit according to Claim 2, wherein the scaling circuit (1204) of each current supply circuit ($12_1$-$12_k$) comprises a first Field-Effect Transistor, FET, (1212) connected between a regulated voltage ($V_{REG}$) and the respective output terminal ($OUT_1$-$OUT_k$), and
wherein the current sensor (122) of each current supply circuit ($12_1$-$12_k$) comprises a second FET (1222) configured to provide the measurement current ($i_{MON}$) of the current supply circuit ($12_1$-$12_k$), wherein said second FET (1222) is a scaled version of said first FET (1212) according to a second scaling factor and the current supply circuit ($12_1$-$12_k$) is configured such that the gate-source voltage of said second FET (1222) corresponds to the gate-source voltage of said first FET (1212).

4. The power supply circuit according to Claim 3, wherein the ratio between said first scaling factor and said second scaling factor is one.

5. The power supply circuit according to Claim 3 or Claim 4, wherein each current supply circuit ($12_1$-$12_k$) comprises:

   - a first resistance (1206) connected between said regulated voltage ($V_{REG}$) and an output of said current digital-to-analog converter (1200);
   - a second resistance (1208) connected in series with the current path of said first FET (1212) between said regulated voltage ($V_{REG}$) and the respective output terminal ($OUT_1$-$OUT_k$),
   - an operational amplifier (1210) configured to drive the gate-source voltage of said first FET (1212) such that the voltage-drop at said second resistance (1208) corresponds to the voltage-drop at said first resistance (1206);
   - a third resistance (1220) connected in series with the current path of said second FET (1222) to said regulated voltage ($V_{REG}$), wherein the gate terminal of said second FET (1222) is connected to the gate terminal of said first FET (1212).

6. The power supply according to any of the previous claims, wherein said one or more digital threshold control signals (TH) comprise a second digital control signal (Curr_Set_TH), and wherein said comparison circuit (180) comprises:

   - a further current digital-to-analog converter (1800) configured to receive a second reference current ($i_{REF}'$) and said second digital control signal (Curr_Set_TH), wherein said second digital control signal (Curr_Set_TH) is indicative of a second multiplier, and said further current digital-to-analog converter (1800) is configured to generate said threshold current ($i_{TH}$) by multiplying said second reference current ($i_{REF}'$) with said second multiplier.

7. The power supply circuit according to Claim 6, wherein said control circuit (182) is configured to:

   - during said first phase (PH1), set said second digital control signal (Curr_Set _TH) to a first value being smaller than said selected digital control signal (Curr_Set_CHi) by a given first percentage, and
   - during said second phase (PH2), set said second digital control signal (Curr_Set _TH) to a second value being greater than said selected digital control signal (Curr_Set_CHi) by a given second percentage.

8. The power supply circuit according to Claim 6, wherein said one or more digital threshold control signals (TH) comprise a reference current selection signal (CTH), and wherein said control circuit (182) is configured to:

   - during said first phase (PH1), set said second digital control signal (Curr_Set_TH) to the value of said selected digital control signal (Curr_Set_CHi) and select (SREF) via said reference current selection signal (CTH) as said second reference current ($i_{REF}'$) a current ($i_{REFA}$) having a value being smaller than said first reference current ($i_{REF}$) by a given first percentage, and
   - during said second phase (PH2), set said second digital control signal (Curr_Set_TH) to the value of said selected digital control signal (Curr_Set_CHi) and select (SREF) via said reference current selection signal (CTH) as said second reference current ($i_{REF}'$) a current ($i_{REFB}$) having a value being greater than said first reference current ($i_{REF}$) by a given second tolerance percentage.

9. The power supply according to any of the previous claims, wherein said comparison circuit (180) comprises:

   - a summation node (B) configured to provide a current ($i_M$) corresponding to the difference between said selected measurement current ($i_{MONi}$) and said threshold current ($i_{TH}$);

- a current comparator (1804) configured to:

- in response to determining that said current ($i_M$) is greater than zero, de-assert said comparison signal (COMP), and
- in response to determining that said current ($i_M$) is smaller than zero, assert said comparison signal (COMP).

10. The power supply according to any of the previous claims 1 to 8, wherein said comparison circuit (180) comprises:

- a first measurement resistance (Rmon1) configured to be transversed by said threshold current ($i_{TH}$);
- a second measurement resistance (Rmon2) configured to be transversed by said selected measurement current ($i_{MONi}$);
- a voltage comparator (1806) configured to:

- in response to determining that a voltage-drop at said first measurement resistance (Rmon1) is greater than a voltage-drop at said second measurement resistance (Rmon2), assert said comparison signal (COMP),
- in response to determining that the voltage-drop at said first measurement resistance (Rmon1) is smaller than the voltage-drop at said second measurement resistance (Rmon2), de-assert said comparison signal (COMP).

11. A system comprising a power supply circuit (1a) according to any of the previous claims, and at least one load (20) connected to the output terminals ($OUT_1$-$OUT_k$) of said power supply circuit (1a).

12. A method of operating a power supply circuit (1a) according to any of the previous claims 1 to 10, comprising:

- generating said first digital control signals (Curr_Set_CH1-Curr_Set_CHk), whereby said current supply circuits ($12_1$-$12_k$) provide said output currents ($i_1$-$i_k$);
- generating said selection signal (SEL) in order to select via said first multiplexer circuit (184) a measurement current ($i_{MONi}$) and via said second multiplexer circuit (186) a first digital control signal (Curr_Set_CHi) associated with a given current supply circuit ($12_1$-$12_k$);
- generating said one or more digital threshold control signals (TH) as a function of said selected digital control signal (Curr_Set_CHi) in order to:

- during a first phase (PH1), setting via said comparison circuit (180) said threshold current ($i_{TH}$) to a first value ($i_{TH1}$), said first value ($i_{TH1}$) being smaller than an expected value ($i_{MONi,exp}$) for said selected measurement current ($i_{MONi}$) as indicated by said selected digital control signal (Curr_Set_CHi), and
- during a second phase (PH2), setting via said comparison circuit (180) said threshold current ($i_{TH}$) to a second value ($i_{TH2}$), said second value ($i_{TH2}$) being greater than said expected value ($i_{MONi,exp}$) for said selected measurement current ($i_{MONi}$) as indicated by said selected digital control signal (Curr_Set_CHi),

- verifying whether said comparison signal (COMP) generated by said comparison circuit (180) is de-asserted during said first phase (PH1) and asserted during said second phase (PH2),
- in response to determining that said comparison signal (COMP) is de-asserted during said first phase (PH1) and asserted during said second phase (PH2), asserting a status signal (STATUSi), and
- in response to determining that said comparison signal (COMP) is asserted during said first phase (PH1) or de-asserted during said second phase (PH2), de-asserting said status signal (STATUSi).

**Patentansprüche**

1. Stromversorgungsschaltung (la), die Folgendes umfasst:

- eine Vielzahl von Ausgangsanschlüssen ($OUT_1$-$OUT_k$);
- für jeden Ausgangsanschluss ($OUT_1$-$OUT_k$) eine jeweilige Stromversorgungsschaltung ($12_1$-$12_k$), wobei jede Stromversorgungsschaltung ($12_1$-$12_k$) so konfiguriert ist, dass sie einen Ausgangsstrom ($i_1$-$i_k$) an den jeweiligen Ausgangsanschluss ($OUT_1$-$OUT_k$) als Funktion eines jeweiligen ersten digitalen Steuersignals (Curr_Set_CH1-Curr_Set_CHk) bereitstellt, und wobei jede Stromversorgungsschaltung ($12_1$-$12_k$) einen Stromsensor (122) umfasst, der so konfiguriert ist, dass er einen Messstrom ($i_{MON1}$-$i_{MONk}$) bereitstellt, der proportional zu dem jeweiligen Ausgangsstrom ($i_1$-$i_k$) ist;

14

- eine erste Multiplexerschaltung (184), die so konfiguriert ist, dass sie einen ausgewählten Messstrom ($i_{MONi}$) bereitstellt, indem sie einen der Messströme ($i_{MONi}$-$i_{MONk}$) als Funktion eines Auswahlsignals (SEL), das eine ausgewählte Stromversorgungsschaltung ($12_1$-$12_k$) anzeigt, auswählt;

**dadurch gekennzeichnet, dass** die Stromversorgungsschaltung (1a) ferner Folgendes umfasst:

- eine zweite Multiplexerschaltung (186), die so konfiguriert ist, dass sie ein ausgewähltes digitales Steuersignal (Curr_Set_CHi) bereitstellt, indem sie eines der ersten digitalen Steuersignale (Curr_Set_CH1-Curr_Set_CHk) als Funktion des Auswahlsignals (SEL), das eine ausgewählte Stromversorgungsschaltung ($12_1$-$12_k$) anzeigt, auswählt;
- eine Vergleichsschaltung (180), die für Folgendes konfiguriert ist:
- Erzeugen eines Schwellenstroms ($i_{TH}$) als Funktion eines oder mehrerer digitaler Schwellensteuersignale (TH),
- Vergleichen des ausgewählten Messstroms ($i_{MONi}$) mit dem Schwellenstrom ($i_{TH}$),
- als Reaktion auf das Bestimmen, dass der ausgewählte Messstrom ($i_{MONi}$) größer als der Schwellenstrom ($i_{TH}$) ist, Deaktivieren eines Vergleichssignals (COMP), und
- als Reaktion auf das Bestimmen, dass der ausgewählte Messstrom ($i_{MONi}$) kleiner als der Schwellenstrom ($i_{TH}$) ist, Aktivieren des Vergleichssignals (COMP);
- eine Steuerschaltung (182), die so konfiguriert ist, dass sie die folgenden Vorgänge periodisch wiederholt:

- Erzeugen des Auswahlsignals (SEL), um einen Messstrom ($i_{MONi}$) und ein erstes digitales Steuersignal (Curr_Set_CHi) auszuwählen, die einer gegebenen Stromversorgungsschaltung ($12_1$-$12_k$) zugeordnet sind;
- Erzeugen des einen oder der mehreren digitalen Schwellensteuersignale (TH) als Funktion des ausgewählten digitalen Steuersignals (Curr_Set_CHi), um:

- während einer ersten Phase (PH1) über die Vergleichsschaltung (180) den Schwellenstrom ($i_{TH}$) auf einen ersten Wert ($i_{TH1}$) einzustellen, wobei der erste Wert ($i_{TH1}$) kleiner als ein erwarteter Wert ($i_{MONi,exp}$) für den ausgewählten Messstrom ($i_{MONi}$) ist, wie durch das ausgewählte digitale Steuersignal (Curr_Set_CHi) angezeigt, und
- während einer zweiten Phase (PH2) über die Vergleichsschaltung (180) den Schwellenstrom ($i_{TH}$) auf einen zweiten Wert ($i_{TH2}$) einzustellen, wobei der zweite Wert ($i_{TH2}$) größer als der erwartete Wert ($i_{MONi,exp}$) für den ausgewählten Messstrom ($i_{MONi}$) ist, wie durch das ausgewählte digitale Steuersignal (Curr_Set_CHi) angezeigt,
- zu überprüfen, ob das Vergleichssignal (COMP) während der ersten Phase (PH1) deaktiviert und während der zweiten Phase (PH2) aktiviert wird,
- als Reaktion auf das Bestimmen, dass das Vergleichssignal (COMP) während der ersten Phase (PH1) deaktiviert und während der zweiten Phase (PH2) aktiviert wird, ein Statussignal (STATUSi) zu aktivieren, und
- als Reaktion auf das Bestimmen, dass das Vergleichssignal (COMP) während der ersten Phase (PH1) aktiviert oder während der zweiten Phase (PH2) deaktiviert wird, das Statussignal (STATUSi) zu deaktivieren.

2. Stromversorgungsschaltung nach Anspruch 1, wobei jede Stromversorgungsschaltung ($12_1$-$12_k$) Folgendes umfasst:

- ein Digital-Analog-Stromwandler (1200), der so konfiguriert ist, dass er einen ersten Referenzstrom ($i_{REF}$) und das jeweilige erste digitale Steuersignal (Curr_Set_CH1- Curr_Set_CHk) empfängt, wobei das erste digitale Steuersignal (Curr_Set_CH1-Curr_Set_CHk) einen ersten Multiplikator anzeigt, und der Digital-Analog-Stromwandler (1200) so konfiguriert ist, dass er einen ersten Strom ($i_{SET}$) erzeugt, indem er den ersten Referenzstrom ($i_{REF}$) mit dem ersten Multiplikator multipliziert; und
- eine Skalierungsschaltung (1204), die so konfiguriert ist, dass sie den Ausgangsstrom ($i_1$-$i_k$) erzeugt, indem sie eine verstärkte Version des ersten Stroms ($i_{SET}$) gemäß einem ersten Skalierungsfaktor erzeugt.

3. Stromversorgungsschaltung nach Anspruch 2, wobei die Skalierungsschaltung (1204) jeder Stromversorgungsschaltung ($12_1$-$12_k$) einen ersten Feldeffekttransistor, FET, (1212) umfasst, der zwischen einer geregelten Spannung ($V_{REG}$) und dem jeweiligen Ausgangsanschluss ($OUT_1$-$OUT_k$) verbunden ist, und wobei der Stromsensor (122) jeder Stromversorgungsschaltung ($12_1$-$12_k$ einen zweiten FET (1222) umfasst, der so konfiguriert ist, dass er den Messstrom ($i_{MON}$) der Stromversorgungsschaltung ($12_1$-$12_k$) bereitstellt, wobei der zweite FET (1222) eine skalierte Version des ersten FET (1212) gemäß einem zweiten Skalierungsfaktor ist und die Stromversorgungsschaltung ($12_1$-$12_k$) so konfiguriert ist, dass die Gate-Source-Spannung des zweiten FET (1222) der Gate-Source-Spannung des ersten FET (1212) entspricht.

4.  Stromversorgungsschaltung nach Anspruch 3, wobei das Verhältnis zwischen dem ersten Skalierungsfaktor und dem zweiten Skalierungsfaktor eins ist.

5.  Stromversorgungsschaltung nach Anspruch 3 oder Anspruch 4, wobei jede Stromversorgungsschaltung ($12_1$-$12_k$) Folgendes umfasst:

    - einen ersten Widerstand (1206), der zwischen der geregelten Spannung ($V_{REG}$) und einem Ausgang des Digital-Analog-Stromwandlers (1200) verbunden ist;
    - einen zweiten Widerstand (1208), der mit dem Strompfad des ersten FET (1212) zwischen der geregelten Spannung ($V_{REG}$) und dem jeweiligen Ausgangsanschluss ($OUT_1$-$OUT_k$) in Reihe verbunden ist,
    - einen Betriebsverstärker (1210), der so konfiguriert ist, dass er die Gate-Source-Spannung des ersten FET (1212) antreibt, sodass der Spannungsabfall an dem zweiten Widerstand (1208) dem Spannungsabfall an dem ersten Widerstand (1206) entspricht;
    - einen dritten Widerstand (1220), der mit dem Strompfad des zweiten FET (1222) in Reihe mit der geregelten Spannung ($V_{REG}$) verbunden ist, wobei der Gate-Anschluss des zweiten FET (1222) mit dem Gate-Anschluss des ersten FET (1212) verbunden ist.

6.  Stromversorgungsschaltung nach einem der vorhergehenden Ansprüche, wobei das eine oder die mehreren digitalen Schwellensteuersignale (TH) ein zweites digitales Steuersignal (Curr_Set_TH) umfassen, und wobei die Vergleichsschaltung (180) Folgendes umfasst:

    - einen weiteren Digital-Analog-Stromwandler (1800), der so konfiguriert ist, dass er einen zweiten Referenzstrom ($i_{REF}$') und das zweite digitale Steuersignal (Curr_Set_TH) empfängt, wobei das zweite digitale Steuersignal (Curr_Set_TH) einen zweiten Multiplikator anzeigt und der weitere Digital-Analog-Stromwandler (1800) so konfiguriert ist, dass er den Schwellenstrom ($i_{TH}$) erzeugt, indem er den zweiten Referenzstrom ($i_{REF}$') mit dem zweiten Multiplikator multipliziert.

7.  Stromversorgungsschaltung nach Anspruch 6, wobei die Steuerschaltung (182) für Folgendes konfiguriert ist:

    - während der ersten Phase (PH1), Einstellen des zweiten digitalen Steuersignals (Curr_Set_TH) auf einen ersten Wert, der um einen gegebenen ersten Prozentsatz kleiner als das ausgewählte digitale Steuersignal (Curr_Set_CHi) ist, und
    - während der zweiten Phase (PH2), Einstellen des zweiten digitalen Steuersignals (Curr_Set_TH) auf einen zweiten Wert, der um einen gegebenen zweiten Prozentsatz größer als das ausgewählte digitale Steuersignal (Curr_Set_CHi) ist.

8.  Stromversorgungsschaltung nach Anspruch 6, wobei das eine oder die mehreren digitalen Schwellensteuersignale (TH) ein Referenzstrom-Auswahlsignal (CTH) umfassen, und wobei die Steuerschaltung (182) für Folgendes konfiguriert ist:

    - während der ersten Phase (PH1), Einstellen des zweiten digitalen Steuersignals (Curr_Set_TH) auf den Wert des ausgewählten digitalen Steuersignals (Curr_Set_CHi) und Auswählen, über das Referenzstrom-Auswahlsignal (CTH) als zweiten Referenzstrom ($i_{REF}$'), eines Stroms ($i_{REFA}$), dessen Wert um einen gegebenen ersten Prozentsatz kleiner als der erste Referenzstrom ($i_{REF}$') ist, und
    - während der zweiten Phase (PH2), Einstellen des zweiten digitalen Steuersignals (Curr_Set_TH) auf den Wert des ausgewählten digitalen Steuersignals (Curr_Set_CHi) und Auswählen, über das Referenzstrom-Auswahlsignal (CTH) als zweiten Referenzstrom ($i_{REF}$'), eines Stroms ($i_{REFB}$), dessen Wert um einen gegebenen zweiten Toleranzprozentsatz größer als der erste Referenzstrom ($i_{REF}$) ist.

9.  Stromversorgungsschaltung nach einem der vorhergehenden Ansprüche, wobei die Vergleichsschaltung (180) Folgendes umfasst:

    - einen Summierknoten (B), der so konfiguriert ist, dass er einen Strom ($i_M$) bereitstellt, der der Differenz zwischen dem ausgewählten Messstrom ($i_{MONi}$) und dem Schwellenstrom ($i_{TH}$) entspricht;

- einen Stromkomparator (1804), der für Folgendes konfiguriert ist:

- als Reaktion auf das Bestimmen, dass der Strom ($i_M$) größer als Null ist, Deaktivieren des Vergleichssignals (COMP), und
- als Reaktion auf das Bestimmen, dass der Strom ($i_M$) kleiner als Null ist, Aktivieren des Vergleichssignals (COMP).

10. Stromversorgungsschaltung nach einem der Ansprüche 1 bis 8, wobei die Vergleichsschaltung (180) Folgendes umfasst:

- einen ersten Messwiderstand (Rmon1), der so konfiguriert ist, dass er von dem Schwellenstrom ($i_{TH}$) durchquert wird;
- einen zweiten Messwiderstand (Rmon2), der so konfiguriert ist, dass er von dem ausgewählten Messstrom ($i_{MONi}$) durchquert wird;
- einen Spannungskomparator (1806), der für Folgendes konfiguriert ist:

- als Reaktion auf das Bestimmen, dass ein Spannungsabfall an dem ersten Messwiderstand (Rmon1) größer als ein Spannungsabfall an dem zweiten Messwiderstand (Rmon2) ist, Aktivieren des Vergleichssignals (COMP),
- als Reaktion auf das Bestimmen, dass der Spannungsabfall an dem ersten Messwiderstand (Rmon1) kleiner als der Spannungsabfall an dem zweiten Messwiderstand (Rmon2) ist, Deaktivieren des Vergleichssignals (COMP).

11. System, das eine Stromversorgungsschaltung (1a) nach einem der vorhergehenden Ansprüche und mindestens eine Last (20) umfasst, die mit den Ausgangsanschlüssen ($OUT_1$-$OUT_k$) der Stromversorgungsschaltung (1a) verbunden ist.

12. Verfahren zum Betreiben einer Stromversorgungsschaltung (Ia) nach einem der vorhergehenden Ansprüche 1 bis 10, das Folgendes umfasst:

- Erzeugen der ersten digitalen Steuersignale (Curr_Set_CH1-Curr_Set_CHk), wobei die Stromversorgungsschaltungen ($12_1$-$12_k$) die Ausgangsströme ($i_1$-$i_k$) bereitstellen;
- Erzeugen des Auswahlsignals (SEL), um über die erste Multiplexerschaltung (184) einen Messstrom ($i_{MONi}$) und über die zweite Multiplexerschaltung (186) ein erstes digitales Steuersignal (Curr_Set_CHi) auszuwählen, die einer gegebenen Stromversorgungsschaltung ($12_1$-$12_k$) zugeordnet sind;
- Erzeugen des einen oder der mehreren digitalen Schwellensteuersignale (TH) als Funktion des ausgewählten digitalen Steuersignals (Curr_Set_CHi), um:

- während einer ersten Phase (PH1) über die Vergleichsschaltung (180) den Schwellenstrom ($i_{TH}$) auf einen ersten Wert ($i_{TH1}$) einzustellen, wobei der erste Wert ($i_{TH1}$) kleiner als ein erwarteter Wert ($i_{MONi,exp}$) für den ausgewählten Messstrom ($i_{MONi}$) ist, wie durch das ausgewählte digitale Steuersignal (Curr_Set_CHi) angezeigt, und
- während einer zweiten Phase (PH2) über die Vergleichsschaltung (180) den Schwellenstrom ($i_{TH}$) auf einen zweiten Wert ($i_{TH2}$) einzustellen, wobei der zweite Wert ($i_{TH2}$) größer als der erwartete Wert ($i_{MONi,exp}$) für den ausgewählten Messstrom ($i_{MONi}$) ist, wie durch das ausgewählte digitale Steuersignal (Curr_Set_CHi) angezeigt,
- zu überprüfen, ob das durch die Vergleichsschaltung (180) erzeugte Vergleichssignal (COMP) während der ersten Phase (PH1) deaktiviert und während der zweiten Phase (PH2) aktiviert wird,
- als Reaktion auf das Bestimmen, dass das Vergleichssignal (COMP) während der ersten Phase (PH1) deaktiviert und während der zweiten Phase (PH2) aktiviert wird, ein Statussignal (STATUSi) zu aktivieren, und
- als Reaktion auf das Bestimmen, dass das Vergleichssignal (COMP) während der ersten Phase (PH1) aktiviert oder während der zweiten Phase (PH2) deaktiviert wird, das Statussignal (STATUSi) zu deaktivieren.

**EP 4 525 557 B1**

**Revendications**

1. Circuit d'alimentation électrique (1a) comprenant :

   - une pluralité de bornes de sortie ($OUT_1$-$OUT_k$) ;
   - pour chaque borne de sortie ($OUT_1$-$OUT_k$), un circuit d'alimentation en courant ($12_1$-$12_k$) respectif, dans lequel chaque circuit d'alimentation en courant ($12_1$-$12_k$) est configuré pour fournir un courant de sortie ($i_1$-$i_k$) à la borne de sortie ($OUT_1$-$OUT_k$) respective en fonction d'un premier signal numérique de commande (Curr_Set_CH1-Curr_Set_CHk) respectif, et dans lequel chaque circuit d'alimentation en courant ($12_1$-$12_k$) comprend un capteur de courant (122) configuré pour fournir un courant de mesure ($i_{MON1}$-$i_{MONk}$) qui est proportionnel au courant de sortie ($i_1$-$i_k$) respectif ;
   - un premier circuit multiplexeur (184) configuré pour fournir un courant de mesure ($i_{MONi}$) sélectionné par la sélection de l'un des courants de mesure ($i_{MONi}$-$i_{MONk}$) en fonction d'un signal de sélection (SEL) indiquant un circuit d'alimentation en courant ($12_1$-$12_k$) sélectionné ; **caractérisé en ce que** ledit circuit d'alimentation électrique (1a) comprend en outre :

     - un deuxième circuit multiplexeur (186) configuré pour fournir un signal numérique de commande (Curr_Set_CHi) sélectionné par la sélection de l'un des premiers signaux numériques de commande (Curr_Set_CH1-Curr_Set_CHk) en fonction dudit signal de sélection (SEL) indiquant un circuit d'alimentation en courant ($12_1$-$12_k$) sélectionné ;
     - un circuit de comparaison (180) configuré pour :

       - générer un courant seuil ($i_{TH}$) en fonction d'un ou de plusieurs signaux numériques de commande de seuil (TH),
       - comparer le courant de mesure ($i_{MONi}$) sélectionné avec ledit courant seuil ($i_{TH}$),
       - en réponse à la détermination que ledit courant de mesure ($i_{MONi}$) sélectionné est supérieur audit courant seuil ($i_{TH}$), désappliquer un signal de comparaison (COMP), et
       - en réponse à la détermination que ledit courant de mesure ($i_{MONi}$) sélectionné est inférieur audit courant seuil ($i_{TH}$), appliquer ledit signal de comparaison (COMP) ;

     - un circuit de commande (182) configuré pour répéter les opérations suivantes de manière périodique :

       - générer ledit signal de sélection (SEL) afin de sélectionner un courant de mesure ($i_{MONi}$) et un premier signal numérique de commande (Curr_Set_CHi) associé à un circuit d'alimentation en courant ($12_1$-$12_k$) donné ;
       - générer lesdits un ou plusieurs signaux numériques de commande de seuil (TH) en fonction dudit signal numérique de commande (Curr_Set_CHi) sélectionné afin de :

         - pendant une première phase (PH1), régler, via ledit circuit de comparaison (180), ledit courant seuil ($i_{TH}$) sur une première valeur ($i_{TH1}$), ladite première valeur ($i_{TH1}$) étant inférieure à une valeur attendue ($i_{MONi,exp}$) pour ledit courant de mesure ($i_{MONi}$) sélectionné comme indiqué par ledit signal numérique de commande (Curr_Set_CHi) sélectionné, et
         - pendant une deuxième phase (PH2), régler, via ledit circuit de comparaison (180), ledit courant seuil ($i_{TH}$) sur une deuxième valeur ($i_{TH2}$), ladite deuxième valeur ($i_{TH2}$) étant supérieure à ladite valeur attendue ($i_{MONi,exp}$) pour ledit courant de mesure ($i_{MONi}$) sélectionné comme indiqué par ledit signal numérique de commande (Curr_Set_CHi) sélectionné,
         - vérifier si ledit signal de comparaison (COMP) est désappliqué pendant ladite première phase (PH1) et appliqué pendant ladite deuxième phase (PH2),
         - en réponse à la détermination que ledit signal de comparaison (COMP) est désappliqué pendant ladite première phase (PH1) et appliqué pendant ladite deuxième phase (PH2), appliquer un signal de statut (STATUSi), et
         - en réponse à la détermination que ledit signal de comparaison (COMP) est appliqué pendant ladite première phase (PH1) ou désappliqué pendant ladite deuxième phase (PH2), désappliquer ledit signal de statut (STATUSi).

2. Circuit d'alimentation électrique selon la revendication 1, où chaque circuit d'alimentation électrique ($12_1$-$12_k$) comprend :

   - un convertisseur numérique-analogique de courant (1200) configuré pour recevoir un premier courant de

18

référence ($i_{REF}$) et le premier signal numérique de commande (Curr_Set_CH1-Curr_Set_CHk) respectif, dans lequel ledit premier signal numérique de commande (Curr_Set_CH1-Curr_Set_CHk) est indicatif d'un premier multiplicateur, et ledit convertisseur numérique-analogique de courant (1200) est configuré pour générer un premier courant ($i_{SET}$) par la multiplication dudit premier courant de référence ($i_{REF}$) avec ledit premier multiplicateur ; et

- un circuit de mise à l'échelle (1204) configuré pour générer ledit courant de sortie ($i_1$-$i_k$) par la génération d'une version amplifiée dudit premier courant ($i_{SET}$) selon un premier facteur de mise à l'échelle.

3. Circuit d'alimentation électrique selon la revendication 2, dans lequel le circuit de mise à l'échelle (1204) de chaque circuit d'alimentation électrique ($12_1$-$12_k$) comprend un premier transistor à effet de champ, FET, (1212) connecté entre une tension régulée ($V_{REG}$) et la borne de sortie ($OUT_1$-$OUT_k$) respective, et

dans lequel le capteur de courant (122) de chaque circuit d'alimentation en courant ($12_1$-$12_k$) comprend un deuxième FET (1222) configuré pour fournir le courant de mesure ($i_{MON}$) du circuit d'alimentation en courant ($12_1$-$12_k$), dans lequel ledit deuxième FET (1222) est une version mise à l'échelle dudit premier FET (1212) selon un deuxième facteur de mise à l'échelle et le circuit d'alimentation en courant ($12_1$-$12_k$) est configuré de sorte que la tension de grille-source dudit deuxième FET (1222) corresponde à la tension grille-source dudit premier FET (1212).

4. Circuit d'alimentation électrique selon la revendication 3, dans lequel le rapport entre ledit premier facteur d'échelle et ledit deuxième facteur d'échelle vaut un.

5. Circuit d'alimentation électrique selon la revendication 3 ou la revendication 4, dans lequel chaque circuit d'alimentation électrique ($12_1$-$12_k$) comprend :

- une première résistance (1206) connectée entre ladite tension régulée ($V_{REG}$) et une sortie dudit convertisseur numérique-analogique de courant (1200) ;
- une deuxième résistance (1208) connectée en série avec le chemin de courant dudit premier FET (1212) entre ladite tension régulée ($V_{REG}$) et la borne de sortie ($OUT_1$-$OUT_k$) respective,
- un amplificateur opérationnel (1210) configuré pour exciter la tension grille-source dudit premier FET (1212) de sorte que la chute de tension au niveau de ladite deuxième résistance (1208) corresponde à la chute de tension au niveau de ladite première résistance (1206) ;
- une troisième résistance (1220) connectée en série avec le chemin de courant dudit deuxième FET (1222) à ladite tension régulée ($V_{REG}$), dans lequel la borne de grille dudit deuxième FET (1222) est connectée à la borne de grille dudit premier FET (1212).

6. Alimentation électrique selon l'une quelconque des revendications précédentes, dans laquelle lesdits un ou plusieurs signaux numériques de commande de seuil (TH) comprennent un deuxième signal numérique de commande (Curr_Set_TH), et dans laquelle ledit circuit de comparaison (180) comprend :

- un convertisseur numérique-analogique de courant supplémentaire (1800) configuré pour recevoir un deuxième courant de référence ($i_{REF}'$) et ledit deuxième signal numérique de commande (Curr_Set_TH), dans laquelle ledit deuxième signal numérique de commande (Curr_Set_TH) est indicatif d'un deuxième multiplicateur, et ledit convertisseur numérique-analogique de courant supplémentaire (1800) est configuré pour générer ledit courant de seuil ($i_{TH}$) par la multiplication dudit deuxième courant de référence ($i_{REF}'$) avec ledit deuxième multiplicateur.

7. Circuit d'alimentation électrique selon la revendication 6, dans lequel ledit circuit de commande (182) est configuré pour :

- pendant ladite première phase (PH1), régler ledit deuxième signal numérique de commande (Curr_Set_TH) sur une première valeur qui est inférieure audit signal numérique de commande (Curr_Set_CHi) sélectionné d'un premier pourcentage donné, et
- pendant ladite deuxième phase (PH2), régler ledit deuxième signal numérique de commande (Curr_Set_TH) sur une deuxième valeur qui est supérieure audit signal numérique de commande (Curr_Set_CHi) sélectionné d'un deuxième pourcentage donné.

8. Circuit d'alimentation électrique selon la revendication 6, dans lequel lesdits un ou plusieurs signaux numériques de commande de seuil (TH) comprennent un signal de sélection de courant de référence (CTH), et dans lequel ledit circuit de commande (182) est configuré pour :

- pendant ladite première phase (PH1), régler ledit deuxième signal numérique de commande (Curr_Set_TH) sur la valeur dudit signal numérique de commande (Curr_Set_CHi) sélectionné et sélectionner (SREF), via ledit signal de sélection de courant de référence (CTH) comme étant ledit deuxième courant de référence ($i_{REF}$'), un courant ($i_{REFA}$) ayant une valeur qui est inférieure audit premier courant de référence ($i_{REF}$) d'un premier pourcentage donné, et

- pendant ladite deuxième phase (PH2), régler ledit deuxième signal numérique de commande (Curr_Set_TH) sur la valeur dudit signal numérique de commande (Curr_Set_CHi) sélectionné et sélectionner (SREF), via ledit signal de sélection de courant de référence (CTH) comme étant ledit deuxième courant de référence ($i_{REF}$'), un courant ($i_{REFB}$) ayant une valeur qui est supérieure audit premier courant de référence ($i_{REF}$) d'un deuxième pourcentage de tolérance donné.

9. Alimentation électrique selon l'une quelconque des revendications précédentes, dans laquelle ledit circuit de comparaison (180) comprend :

   - un nœud d'addition (B) configuré pour fournir un courant ($i_M$) correspondant à la différence entre ledit courant de mesure ($i_{MONi}$) sélectionné et ledit courant seuil ($i_{TH}$) ;
   - un comparateur de courant (1804) configuré pour :

      - en réponse à la détermination que ledit courant ($i_M$) est supérieur à zéro, désappliquer ledit signal de comparaison (COMP), et
      - en réponse à la détermination que ledit courant ($i_M$) est inférieur à zéro, appliquer ledit signal de comparaison (COMP).

10. Alimentation électrique selon l'une quelconque des revendications 1 à 8 précédentes, dans laquelle ledit circuit de comparaison (180) comprend :

    - une première résistance de mesure (Rmon1) configurée pour être traversée par ledit courant seuil ($i_{TH}$) ;
    - une deuxième résistance de mesure (Rmon2) configurée pour être traversée par ledit courant de mesure ($i_{MONi}$) sélectionné ;
    - un comparateur de tension (1806) configuré pour :

       - en réponse à la détermination qu'une chute de tension au niveau de ladite première résistance de mesure (Rmon1) est supérieure à une chute de tension au niveau de ladite deuxième résistance de mesure (Rmon2), appliquer ledit signal de comparaison (COMP),
       - en réponse à la détermination que la chute de tension au niveau de ladite première résistance de mesure (Rmon1) est inférieure à la chute de tension au niveau de ladite deuxième résistance de mesure (Rmon2), désappliquer ledit signal de comparaison (COMP).

11. Système comprenant un circuit d'alimentation électrique (1a) selon l'une quelconque des revendications précédentes, et au moins une charge (20) connectée aux bornes de sortie ($OUT_1$-$OUT_k$) dudit circuit d'alimentation électrique (1a).

12. Procédé de fonctionnement d'un circuit d'alimentation électrique (1a) selon l'une quelconque des revendications 1 à 10 précédentes, comprenant :

    - la génération desdits premiers signaux numériques de commande (Curr_Set_CH1-Curr_Set_CHk), ce par quoi lesdits circuits d'alimentation en courant ($12_1$-$12_k$) fournissent lesdits courants de sortie ($i_1$-$i_k$) ;
    - la génération dudit signal de sélection (SEL) afin de sélectionner, via ledit premier circuit multiplexeur (184), un courant de mesure ($i_{MONi}$) et, via ledit deuxième circuit multiplexeur (186), un premier signal numérique de commande (Curr_Set_CHi) associé à un circuit d'alimentation en courant ($12_1$-$12_k$) donné ;
    - la génération desdits un ou plusieurs signaux numériques de commande de seuil (TH) en fonction dudit signal numérique de commande (Curr_Set_CHi) sélectionné afin de :

       - pendant une première phase (PH1), le réglage, via ledit circuit de comparaison (180), dudit courant seuil ($i_{TH}$) sur une première valeur ($i_{TH1}$), ladite première valeur ($i_{TH1}$) étant inférieure à une valeur attendue ($i_{MONi,exp}$) pour ledit courant de mesure ($i_{MONi}$) sélectionné comme indiqué par ledit signal numérique de commande (Curr_Set_CHi) sélectionné, et
       - pendant une deuxième phase (PH2), le réglage, via ledit circuit de comparaison (180), dudit courant seuil

($i_{TH}$) sur une deuxième valeur ($i_{TH2}$), ladite deuxième valeur ($i_{TH2}$) étant supérieure à ladite valeur attendue ($i_{MONi,exp}$) pour ledit courant de mesure ($i_{MONi}$) sélectionné comme indiqué par ledit signal numérique de commande (Curr_Set_CHi) sélectionné,

- la vérification de si ledit signal de comparaison (COMP) généré par ledit circuit de comparaison (180) est désappliqué pendant ladite première phase (PH1) et appliqué pendant ladite deuxième phase (PH2),

- en réponse à la détermination que ledit signal de comparaison (COMP) est désappliqué pendant ladite première phase (PH1) et appliqué pendant ladite deuxième phase (PH2), l'application d'un signal de statut (STATUSi), et

- en réponse à la détermination que ledit signal de comparaison (COMP) est appliqué pendant ladite première phase (PH1) ou désappliqué pendant ladite deuxième phase (PH2), la désapplication dudit signal de statut (STATUSi).

FIG. 1

FIG. 2

EP 4 525 557 B1

FIG. 3

FIG. 4

EP 4 525 557 B1

# FIG. 5

FIG. 6

## FIG. 7A

## FIG. 7B

## FIG. 7C

## FIG. 7D

FIG. 8

FIG. 9

FIG. 10

# FIG. 11

EP 4 525 557 B1

**EP 4 525 557 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9451664 B2

- US 10893591 B2